(19) Europäisches Patentamt

European Patent Office

Office européen des brevets

(11) **EP 1 209 837 A1**

(12) **EUROPEAN PATENT APPLICATION**
published in accordance with Art. 158(3) EPC

(43) Date of publication:
**29.05.2002 Bulletin 2002/22**

(51) Int Cl.7: **H04J 11/00**

(21) Application number: **01947989.8**

(22) Date of filing: **12.07.2001**

(86) International application number:
**PCT/JP01/06046**

(87) International publication number:
**WO 02/07357 (24.01.2002 Gazette 2002/04)**

(84) Designated Contracting States:
**AT BE CH CY DE DK ES FI FR GB GR IE IT LI LU MC NL PT SE TR**

(30) Priority: **19.07.2000 JP 2000219782**

(71) Applicant: **MITSUBISHI DENKI KABUSHIKI KAISHA
Tokyo 100-8310 (JP)**

(72) Inventor: **MATSUMOTO, Wataru,
Mitsubishi Denki K.K.
Tokyo 100-8310 (JP)**

(74) Representative: **Pfenning, Meinig & Partner GbR
Mozartstrasse 17
80336 München (DE)**

(54) **COMMUNICATION DEVICE AND COMMUNICATION METHOD**

(57)     A transmissions section separates a processing on a fast data buffer path and a processing on an interleaved data buffer in units of tones, allows a fast data buffer to secure a transmission rate to, for example, an extent that communication can be held and outputs data on the communication without being encoded, and allows an interleaved data buffer to secure remaining tones and turbo-encodes and outputs bits on the tones; and a receiving section allocates Fourier-transformed frequency data to the fast data buffer path and the interleaved data buffer path in units of tones, respectively, in which state, the receiving section hard-determines the bits on the tones allocated to the fast data buffer path and turbo-encodes the bits on the tones allocated to the interleaved data buffer path.

FIG.1

## EP 1 209 837 A1

**Description**

TECHNICAL FIELD

The present invention relates to a communication device employing a multi-carrier modulation demodulation system, and particularly relates to a communication device and a communication method capable of holding data communication employing an existing communication line by means of a DMT (Discrete Multi Tone) modulation demodulation system, an OFDM (Orthogonal Frequency Division Multiplex) modulation demodulation system or the like. It is noted, however, that the present invention is not limited to a communication device holding data communication by the DMT modulation demodulation system but applicable to any types of communication devices holding wire communication and wireless communication by the multi-carrier modulation demodulation system and a single-carrier modulation demodulation system through ordinary communication lines.

BACKGROUND ART

Now, conventional communication devices will be described. In case of wideband CDMA (W-CDMA: Code Division Multiple Access) employing SS (Spread Spectrum) communication, for example, turbo coding is proposed as error correction coding far more excellent in performance than convolution coding. With the turbo coding, a sequence obtained by interleaving an information bit sequence is encoded in parallel to an existing encoded sequence. The turbo coding is the to have a similar performance to Shannon limit and is one of the error correction coding methods that attract the greatest attention. In the CDMA system, since the performance of the error correction codes largely influences transmission performance for voice transmission and data transmission, it is possible to considerably improve the transmission characteristic of a communication device by employing the turbo codes.

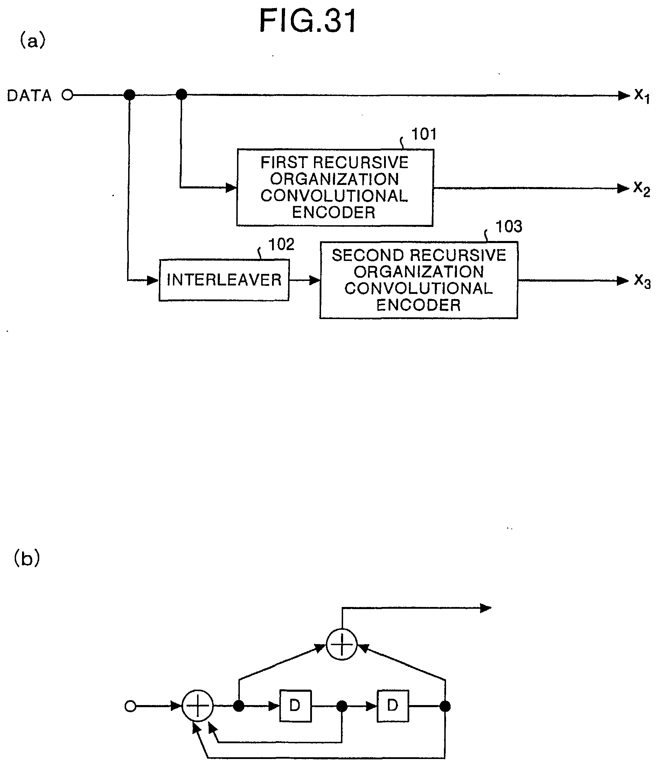

Here, the operations of the transmission system and the receiving system of a conventional communication device employing the above-stated turbo codes will be concretely described. Fig. 31 is a block diagram of a turbo encoder employed in the transmission system. In Fig. 31(a), reference symbol 101 denotes the first recursive organization convolutional encoder convolutional-encoding an information bit sequence and outputting redundant bits, 102 denotes an interleaver, and 103 denotes the second recursive organization convolutional encoder convolutional-encoding the information bit sequence interleaved by the interleaver 102 and outputting redundant bits. Fig. 31(b) shows the internal configurations of the first recursive organization convolutional encoder 101 and the second recursive organization convolutional encoder 103 in which case, these two recursive organization convolutional encoders are encoders outputting only redundant bits, respectively. In addition, the interleaver 102 employed in the above-stated turbo encoder randomly rearranging the information bit sequence.

The turbo encoder having the above-stated configuration simultaneously outputs an information bit sequence: $x_1$, a redundant bit sequence: $x_2$ obtained by encoding the information bit sequence: $x_1$ by the processing of the first recursive organization convolutional encoder 101, and a redundant bit sequence: $x_3$ obtained by encoding the information bit sequence interleaved by the processing of the second recursive organization convolutional encoder 103.

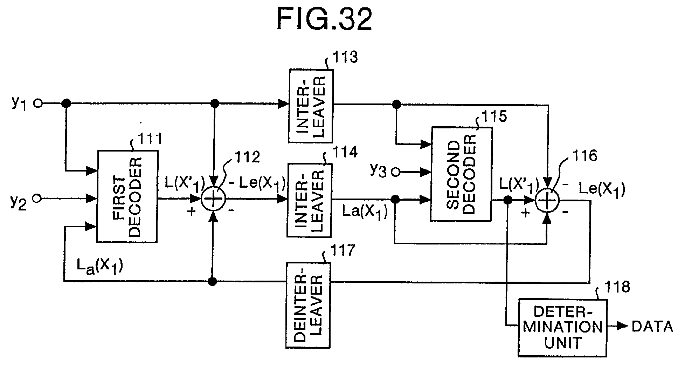

Fig. 32 is a block diagram of a turbo decoder employed in the receiving system. In Fig. 32, reference symbol 111 denotes the first decoder calculating a logarithmic likelihood ratio from a received signal: $y_1$ and a received signal: $y_2$, 112 and 116 denote adders, respectively, 113 and 114 denote interleavers, respectively, 115 denotes the second decoder calculating a logarithmic likelihood ratio from the received signal: $y_1$ and a received signal: $y_3$, 117 denotes a deinterleaver, and 118 denotes a determination unit determining the output of the second decoder 115 and outputting the estimated value of an original information bit sequence. It is noted that the received signals: $y_1$, $y_2$ and $y_3$ are signals which have the influence of transmission line noise and fading on the information bit sequence: $x_1$ and the redundant bit sequences: $x_2$ and $x_3$, respectively.

In turbo decoder having the above-stated configuration, the first decoder 111 first calculates the logarithmic likelihood ratio: $L(x_{1k}')$ of estimated information bits: $x_{1k}'$ estimated from a received signal: $y_{1k}$ and a received signal $y_{2k}$ (where k represents time). Here, a ratio of a probability, in which the information bits: $x_{1k}$ are 1, to a probability in which the information bits: $x_{1k}$ are 0 is obtained. It is noted that reference symbol $Le(x_{1k})$ in Fig. 32 denotes external information and $La(x_{1k})$ denotes prior information which is prior external information.

Next, the adder 112 calculates external information on the second decoder 115 from the logarithmic likelihood ratio which is obtained as a result of the above-stated calculation. Since no prior information is obtained by the first decoding, $La(x_{1k}) = 0$.

Then, the interleavers 113 and 114 interleave the received signal: $y_{1k}$ and the external information: $Le(x_{1k})$ so as to be adjusted to the time of the received signal: $y_3$. Thereafter, the second decoder 115 calculates a logarithmic likelihood ratio: $L(x_{1k}')$ based on the received signal: $y_1$, the received signal: $y_3$ and the external information: $Le(x_{1k})$ calculated in advance, like the first decoder 111. The adder 116 calculates external information: $Le(x_{1k})$. At this moment, the external information rearranged by the deinterleaver 117 is fed back, as the prior information: $La(x_{1k})$, to the first

decoder 111.

Finally, by iteratively executing the above-stated processings a predetermined number of times, this turbo decoder calculates a more accurate logarithmic likelihood ratio. The determination unit 118 makes a determination based on this logarithmic likelihood ratio and estimates an original information bit sequence. To be specific, if the logarithmic likelihood is, for example, "$L(x_{1k}') > 0$", it is determined that the estimated information bit: $x_{1k}'$ is 1 and if "$L(x_{1k}') \leq 0$", for example, it is determined that the estimated information bit: $x_{1k}'$ is 0.

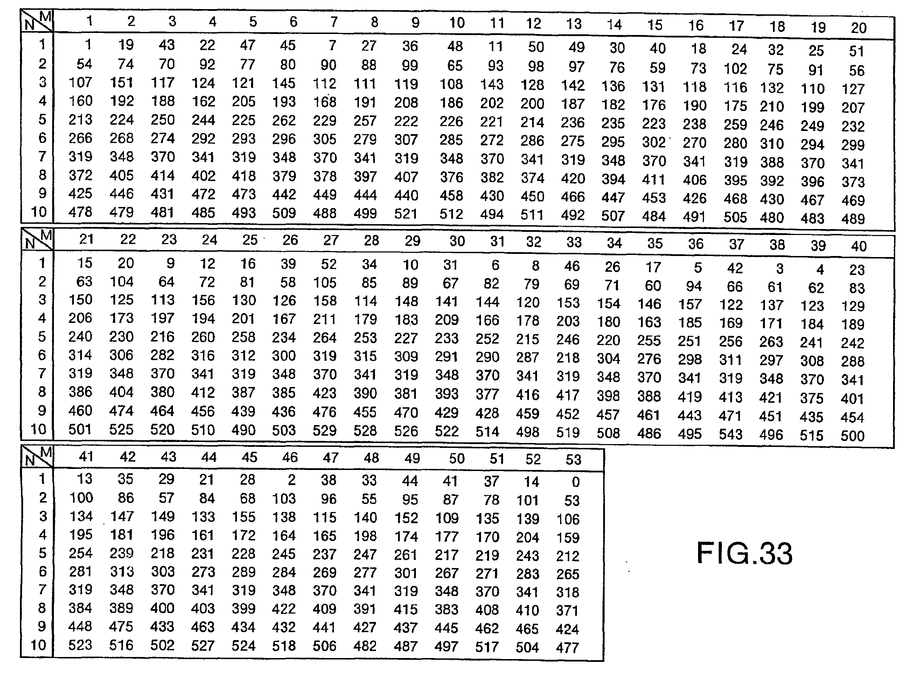

Further, Figs. 33, 34 and 35 show the processing of the interleaver 102 employed in the above-stated turbo encoder. Now, description will be given to the processing of the interleaver 102 for randomly rearranging an information bit sequence.

In the W-CDMA communication, for example, a complex interleaver (to be referred to as "PIL" hereinafter) is normally used as the interleaver. This PIL has the following three features:

(1) To rearrange rows and columns in an N(vertical axis: natural numbers) $\times$ M (horizontal axis: natural numbers) buffer.
(2) To use a pseudo-random pattern employing prime numbers in the rearrangement of bits in rows.
(3) To avoid a critical pattern by the rearrangement of rows.

Here, the operation of a conventional interleaver PIL will be described. If it is assumed, for example, an interleaver length: $L_{turbo}$ = 512 bits, N = 10, M = P = 53 ($L_{turbo}/N \leq P + 1$) and a primitive root: $g_0$ = 2, then a mapping pattern: c (i) is generated as shown in the following equation (1) :

$$c(i) = (g_0 \times c(i-1))\mathrm{mod}P \tag{1},$$

where i = 1, 2, ..., (P-2) and c(0) = 1.

From the above equation (1), the mapping pattern C (i) is determined as {1, 2, 4, 8, 16, 32, 11, 22, 44, 35, 17, 34, 15, 30, 7, 14, 28, 3, 6, 12, 24, 48, 43, 33, 13, 26, 52, 51, 49, 45, 37, 21, 42, 31,9, 18, 36, 19, 38, 23, 46, 39, 25, 50, 47, 41, 29, 5, 10, 20, 40, 27}.

In addition, the PIL rearranges bits by skipping the bits on the above mapping pattern C(i) at the intervals of skipping patterns: $P_{PIP(j)}$ and generates a mapping pattern: Cj(i) having j rows. First, to obtain {$P_{pip(j)}$}, {$q_j$ (j = 0 to N-1) } is determined under the conditions of the following equations (2), (3) and (4):

$$q_0 = 1 \tag{2},$$

$$\mathrm{g.c.d}\ \{q_j, P\text{-}1\} = 1\ (\text{where g.c.d is the greatest common}$$

$$\text{divisor}) \tag{3},$$

$$q_j > 6,\ q_j > q_{j-1}\ (\text{where } j = 1 \text{ to N-1}) \tag{4}$$

Accordingly, {$q_j$} is determined as {1, 7, 11, 13, 17, 19, 23, 29, 31, 37} and {$P_{pip(j)}$} is determined as {37, 31, 29, 23, 19, 17, 13, 11, 7, 1} (where PIP = N-1 to 0).

Fig. 33 shows the result of reading the mapping pattern C(i) while skipping bits based on the skipping pattern: $P_{PIP(j)}$, i.e., the result of rearranging each row using the skip-reading pattern.

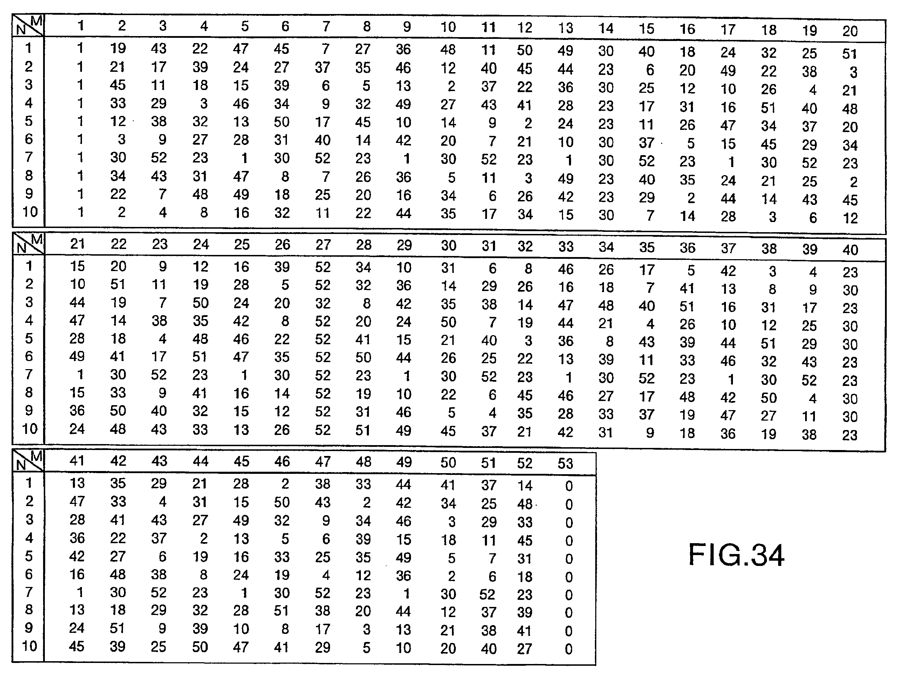

Fig. 34 shows data arrangement if data of an interleaver length: $L_{turbo}$ = 512 bits is mapped on the rearranged mapping pattern stated above. Here, data {0 to 52}, data {53 to 105}, data {106 to 158}, data {159 to 211}, data {212 to 264}, data {265 to 317}, data {318 to 370}, data {371 to 423}, data {424 to 476} and data {477 to 529} are mapped in first, second, third, fourth, fifth, sixth, seventh, eighth, ninth and tenth rows, respectively.

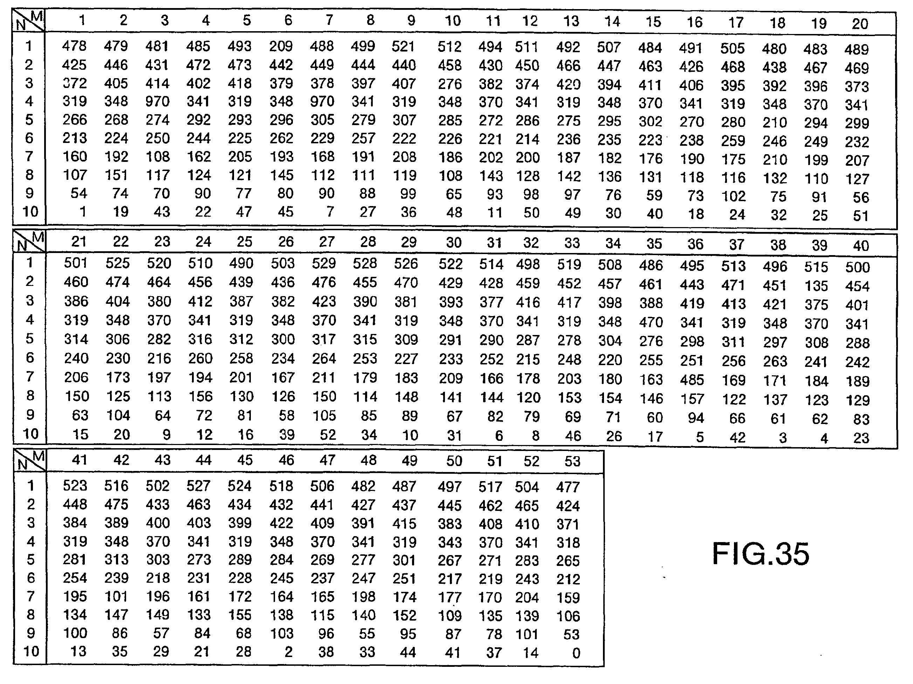

Finally, Fig. 35 shows a finally rearranged pattern. In Fig. 35, the rows are rearranged as shown in the data arrangement of Fig. 35 in accordance with a predetermined order to thereby generate a finally rearranged pattern (in this case, the orders of the respective rows are reversed) . The PIL then reads the rearranged pattern thus generated in units of columns, i.e., longitudinally.

In this way, if the PIL is used as the interleaver, it is possible to provide turbo codes generating code words showing a good weight distribution with a wide range of interleave length (e.g., $L_{turbo}$ = 257 to 8192 bits).

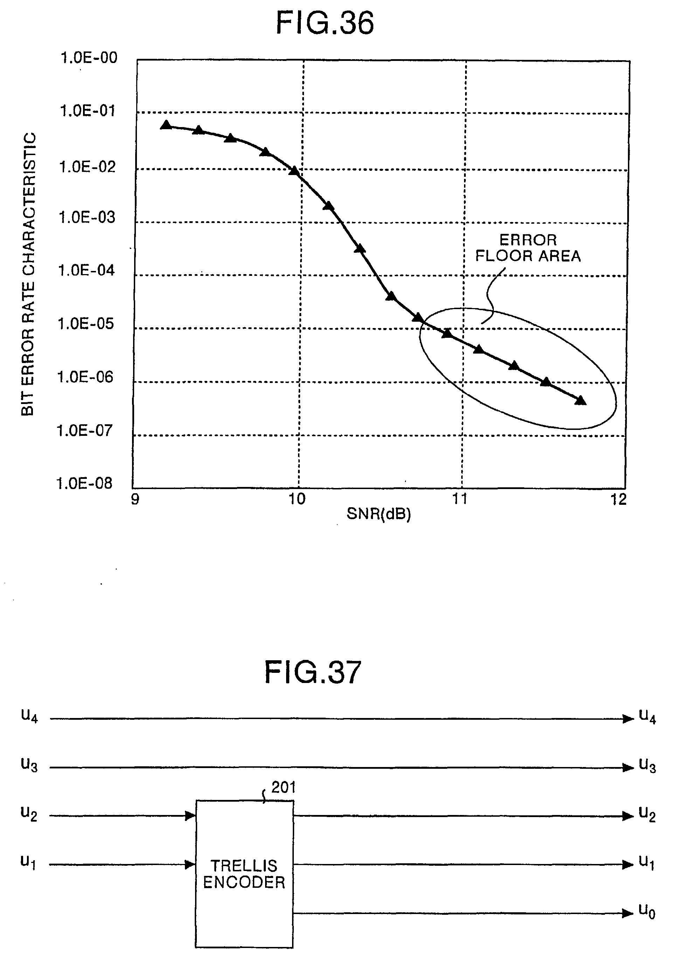

Fig. 36 shows BER (bit error rate) characteristic if the conventional turbo encoder including the above-stated PIL and the conventional turbo decoder are employed. As shown, the BER characteristic improves as SNR is higher.

As can be seen, according to the conventional communication device, by employing the turbo codes as error correction codes, even if the distance between signals is shorter as the number of values of a modulation system increases, it is possible to greatly improve the transmission characteristic of the communication device for voice transmission and data transmission and to obtain more excellent characteristic than that employing the existing convolution codes.

Furthermore, according to the conventional communication device, an entire input information sequence (or all input information sequences when there is a plurality of information bit sequences) is subjected to turbo encoding, a receiving end executes turbo decoding to all the encoded signals and then soft determination is conducted. Concretely, in case of 16QAM, for example, all data of four bits (0000 to 1111: four-bit constellation) are subjected to determination and in case of 256 QAM, for example, all data of eight bits are subjected to determination.

Next, the operation of a conventional communication device using trellis codes for data communication by the DMT modulation demodulation system will be described briefly since there is no conventional communication device using turbo codes . Fig. 37 is a block diagram of a trellis encoder employed in the conventional communication device. In Fig. 37, reference symbol 201 denotes an existing trellis encoder. The trellis encoder 201 outputs, for example, two information bits and one redundant bit when two information bits are inputted.

If data communication is held by the DMT modulation demodulation system using an existing transmission line such as a telephone line, for example, a transmitting end performs a tone ordering processing, i.e., aprocessing for allocating, to a plurality of tones (multi carriers) in preset frequency bands, transmission data having bits which the respective tones can transmit, respectively, based on the S/N ratio (signal-to-noise ratio) of the transmission path (which processing determines respective transmission rates).

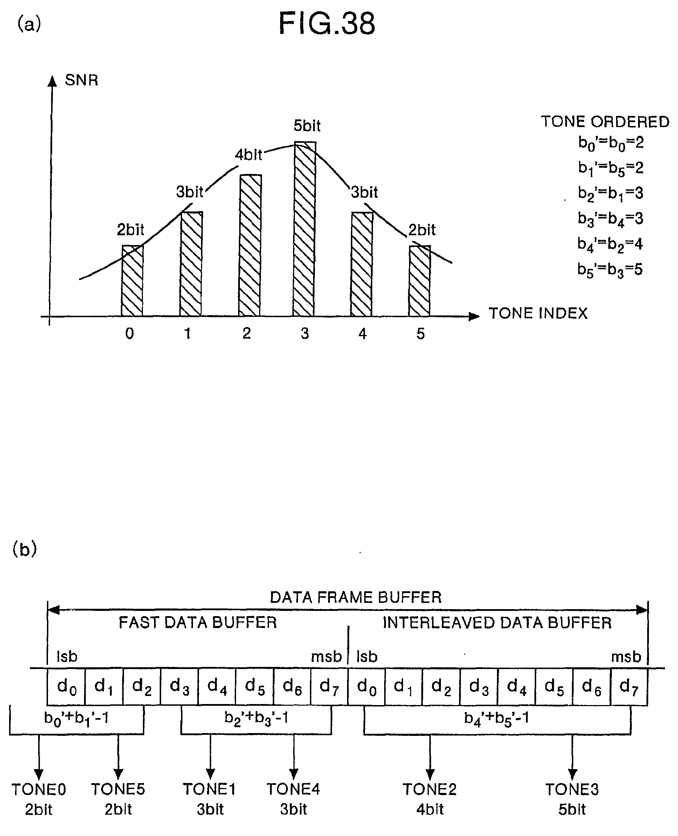

Concretely, as shown in Fig. 38(a), for example, transmission data having bits are allocated to tone0 to tone 5 with respective frequencies according to an S/N ratio. In this case, transmission data of two bits is allocated to each of tone0 and tone 5, transmission data of three bits is allocated to each of tone 1 and tone4, transmission data of four bits is allocated to tone 2, transmission data of five bits is allocated to tone3 and one frame is formed out of these 19 bits (information bits : 16 bits, redundant bits : 3 bits) . It is noted that many bits are allocated to the respective tones compared with data frame buffers shown because redundant bits necessary for error correction are added.

As can be understood from the above, one frame of the transmission data subjected to the tone ordering processing is constituted as shown in, for example, Fig. 38(b). To be specific, the tones are arranged in the ascending order of the number of allocated bits, i.e., tone0 (b0'), tone5 (b1'), tone1 (b2'), tone4 (b3'), tone2 (b4') and tone3 (b5') are arranged in this order, and tone0 and tone5, tone1 and tone4, and tone2 and tone3 are constituted as tone sets, respectively.

The frame processed as shown in Fig. 37 described above is encoded for each tone set. First, if data d0, d1 and d2 of the first tone set (tone0 and tone5) are inputted into the terminals $u_1$, $u_2$, and $u_3$ of the trellis encoder 201, two information bits ($u_1$, $u_2$) and one redundant bit ($u_0$), i.e., three trellis codes and the data of one bit ($u_3$) are outputted. The added one bit corresponds to the redundant bit of the trellis codes.

Next, if data d3, d4, d5, d6 and d7 of the second tone set (tone4, tone1) are inputted into the terminals $u_1$ and $u_2$ of the trellis encoder 201 and terminals $u_3$, $u_4$, ..., then two information bits ($u_1$, $u_2$) and one redundant bit ($u_0$) , i.e., three trellis codes and the other data of three bits ($u_3$, $u_4$, ...) are outputted. The added one bit corresponds to the redundant bit of the trellis codes.

Finally, if data d0, d1, d2, d3, d4, d5, d6 and d7 of the third tone set (tone3, tone2) are inputted into the terminals $u_1$ and $u_2$ of the trellis encoder 201 and terminals $u_4$, $u_5$, ..., then two information bits ($u_1$, $u_2$) and one redundant bit ($u_0$), i.e., three trellis codes and the other data of seven bits ($u_3$, $u_4$, ...) are outputted. The added one bit corresponds to the redundant bit of the trellis codes.

As stated above,if the tone ordering processing based on the respective S/N ratios and the encoding processing are performed, transmission data is multiplexed for each frame. Further, the transmitting end conducts inverse fast Fourier transform (IFFT) to the multiplexed transmission data, converts the digital waveform of the data into an analog waveform by a D/A converter, and feeds the resultant data to a low-pass filter, thereby transmitting final transmission data onto the telephone line.

However, it leaves some room for improvement in, for example, the encoder (corresponding to the recursive organization convolutional encoder) and the interleaver of the conventional communication device adopting the turbo encoder shown in Fig. 31(b). This conventional communication device has disadvantages in that it cannot be said that conventional turbo encoding by means of such an encoder and such an interleaver provides the communication device with optimum transmission characteristic close to Shannon limit, i.e., optimum BER characteristic.

Further, the turbo encoder shown in Fig. 31(b) is employed for the wideband CDMA communication using the SS system. Although the DMT modulation demodulation system has been described in Fig. 37, Fig. 37 shows the communication device which holds data communication using trellis codes. In this way, the conventional communication device which employs the DMT modulation demodulation system for data communication while using an existing transmission line such as a telephone line, disadvantageously fails to adopt turbo codes for error correction.

It is, therefore, an object of the present invention to provide a communication device and a communication method capable of being applied to any type of communication employing the multi-carrier modulation demodulation system or the single-carrier modulation demodulation system, and further capable of greatly improving BER characteristic and transmission efficiency compared with those of conventional techniques by adopting turbo codes for error correction control.

DISCLOSURE OF THE INVENTION

There is provided a communication device according to the present invention, including: a first path having a little delay (corresponding to a first data buffer path in an embodiment below); and a second path to which more delay than the delay of the first path occurs (corresponding to an interleaved data buffer path in an embodiment below) , and further including: a transmission section separating a processing on the first path and a processing on the second path in units of tones, allowing a buffer on the first path to secure a transmission rate to an extent that communication can be held and then outputting data on the communication without being encoded, and allowing a buffer on the second path to secure remaining tones and then turbo-encoding and outputting bits on the tones; and a receiving section allocating Fourier-transformed frequency data to the first path and the second path in units of tones, respectively, and hard-determining bits on the tones allocated to the first path and turbo-decoding bits on the tones allocated to the second path.

There is provided a communication device according to the next invention, including: a first path having a little delay (corresponding to a first data buffer path); and a second path to which more delay than the delay of the first path occurs (corresponding to an interleaved data buffer path), and further including: a transmission section predetermining the number of bits allocated to a buffer on the first path and a buffer on the second path, respectively, outputting the bits on tones allocated to the buffer on the first path without being encoded by a tone ordering processing, outputting the bits on tones allocated to the buffer on the second path with being turbo-encoded, and, if the allocated tones spread over the two buffers, individually processing the tones on the both paths; and a receiving section allocating Fourier-transformed frequency data to the first path and the second path in units of tones, respectively, hard-determining the bits on the tones allocated to the first path and turbo-decoding the bits on the tones allocated to the second path, and individually processing the tones spreading over the two buffers on the both paths.

There is provided a communication device according to the next invention, including: a first path having a little delay (corresponding to a first data buffer path); and a second path to which more delay than the delay of the first path occurs (corresponding to an interleaved data buffer path), and further including: a transmission section allocating bits, other than lower two bits, of respective tones to a buffer on the first path from a bitmap obtained based on an S/N ratio and then outputting the bits allocated to the buffer without being encoded, and allocating the remaining lower two bits to a buffer on the second path and then turbo-encoding and outputting the bits allocated to the buffer; and a receiving section allocating the tones including the bits which are not encoded in Fourier-transformed frequency data to the first path and the tones including the turbo-encoded bits to the second path, respectively, and then hard-determining the bits on the tones allocated to the first path and turbo-decoding the bits on the tones allocated to the second path.

A communication device according to the next invention, a turbo encoder is adapted which includes: a first recursive organization convolutional encoder convolutional-encoding an information bit sequence of one system and outputting first redundant data; a second recursive organization convolutional encoder convolutional-encoding the information bit sequence after being interleaved and outputting second redundant data; and a puncturing circuit thinning out each redundant data at predetermined timing and outputting one of the redundant bits, and wherein if the recursive organization convolutional encoder having a constraint length of "5" and the number of memories is "4" or the constraint length of "4" and the number of memories is "3" is assumed, all connection patterns constituting the encoder are searched; and the encoder satisfying optimal conditions that a distance between two bits "1" of a self-terminating pattern with a specific block length becomes a maximum and that a total weight becomes a maximum in the pattern having the maximum distance, is provided as each of the first and second recursive organization convolutional encoders.

There is provided a communication device according to the next invention, including: a first path having a little delay (corresponding to a first data buffer path); and a second path to which more delay than the delay of the first path occurs (corresponding to an interleaved data buffer path), and further including: a transmission section separating a processing on the first path and a processing on the second path in units of tones, allowing a buffer on the first path to secure a transmission rate to an extent that communication can be held and then outputting data on the communication without being encoded, and allowing a buffer on the second path to secure remaining tones and then turbo-encoding and outputting bits on the tones.

There is provided a communication device according to the next invention, including: a first path having a little delay (corresponding to a first data buffer path); and a second path to which more delay than the delay of the first path occurs (corresponding to an interleaved data buffer path), and further including: a receiving section allocating Fourier-transformed frequency data to the first path and the second path in units of tones, respectively, and hard-determining bits on the tones allocated to the first path and turbo-decoding bits on the tones allocated to the second path.

There is provided a communication device according to the next invention, including: a first path having a little delay (corresponding to a first data buffer path); and a second path to which more delay than the delay of the first path occurs (corresponding to an interleaved data buffer path), and further including: a transmission section predetermining the number of bits allocated to a buffer on the first path and a buffer on the second path, respectively, outputting the bits on tones allocated to the buffer on the first path without being encoded by a tone ordering processing, and, if the allocated tones spread over the two buffers, individually processing the tones on the both paths.

There is provided a communication device according to the next invention, including: a first path having a little delay (corresponding to a first data buffer path); and a second path to which more delay than the delay of the first path occurs (corresponding to an interleaved data buffer path), and further including: a receiving section allocating Fourier-transformed frequency data to the first path and the second path in units of tones, respectively, hard-determining bits on tones allocated to the first path and turbo-decoding bits on tones allocated to the second path, and individually processing the tones spreading over the two buffers on the both paths.

There is provided a communication device according to the next invention, including: a first path having a little delay (corresponding to a first data buffer path); and a second path to which more delay than the delay of the first path occurs (corresponding to an interleaved data buffer path), and further including: a transmission section allocating bits, other than lower two bits, of respective tones to a buffer on the first path from a bitmap obtained based on an S/N ratio and then outputting the bits allocated to the buffer without being encoded, and allocating the remaining lower two bits to a buffer on the second path and then turbo-encoding and outputting the bits allocated to the buffer.

There is provided a communication device according to the next invention, including: a first path having a little delay (corresponding to a first data buffer path); and a second path to which more delay than the delay of the first path occurs (corresponding to an interleaved data buffer path), and further including: a receiving section allocating tones including bits, which are not encoded, in Fourier-transformed frequency data to the first path and tones including turbo-encoded bits to the second path, respectively, and then hard-determining the bits on the tones allocated to the first path and turbo-decoding the bits on the tones allocated to the second path.

There is provided a communication method according to the next invention, using: a first path having a little delay (corresponding to a first data buffer path); and a second path to which more delay than the delay of the first path occurs (corresponding to an interleaved data buffer path), and including: a transmission step of separating a processing on the first path and a processing on the second path in units of tones, allowing a buffer on the first path to secure a transmission rate to an extent that communication can be held and then outputting data on the communication without being encoded, and allowing a buffer on the second path to secure remaining tones and then turbo-encoding and outputting bits on the tones; and a receiving step of allocating Fourier-transformed frequency data to the first path and the second path in units of tones, respectively, and hard-determining bits on the tones allocated to the first path and turbo-decoding bits on the tones allocated to the second path.

There is provided a communication method according to the next invention, using: a first path having a little delay (corresponding to a first data buffer path); and a second path to which more delay than the delay of the first path occurs (corresponding to an interleaved data buffer path), and including: a transmission step of predetermining the number of bits allocated to a buffer on the first path and a buffer on the second path, respectively, outputting the bits on tones allocated to the buffer on the first path without being encoded by a tone ordering processing, outputting the bits on tones allocated to the buffer on the second path with being turbo-encoded, and, if the allocated tones spread over the two buffers, individually processing the tones on the both paths; and a receiving step of allocating Fourier-transformed frequency data to the first path and the second path in units of tones, respectively, hard-determining the bits on the tones allocated to the first path and turbo-decoding the bits on the tones allocated to the second path, and individually processing the tones spreading over the two buffers on the both paths.

There is provided a communication method according to the next invention, using: a first path having a little delay (corresponding to a first data buffer path); and a second path to which more delay than the delay of the first path occurs (corresponding to an interleaved data buffer path) , and including: a transmission step of allocating bits, other than lower two bits, of respective tones to a buffer on the first path from a bitmap obtained based on an S/N ratio and then outputting the bits allocated to the buffer without being encoded, and allocating the remaining lower two bits to a buffer on the second path and then turbo-encoding and outputting the bits allocated to the buffer; and a receiving step of allocating the tones including the bits which are not encoded in Fourier-transformed frequency data to the first path and the tones including the turbo-encoded bits to the second path, respectively, and then hard-determining the bits on the tones allocated to the first path and turbo-decoding the bits on the tones allocated to the second path.

BRIEF DESCRIPTION OF THE DRAWINGS

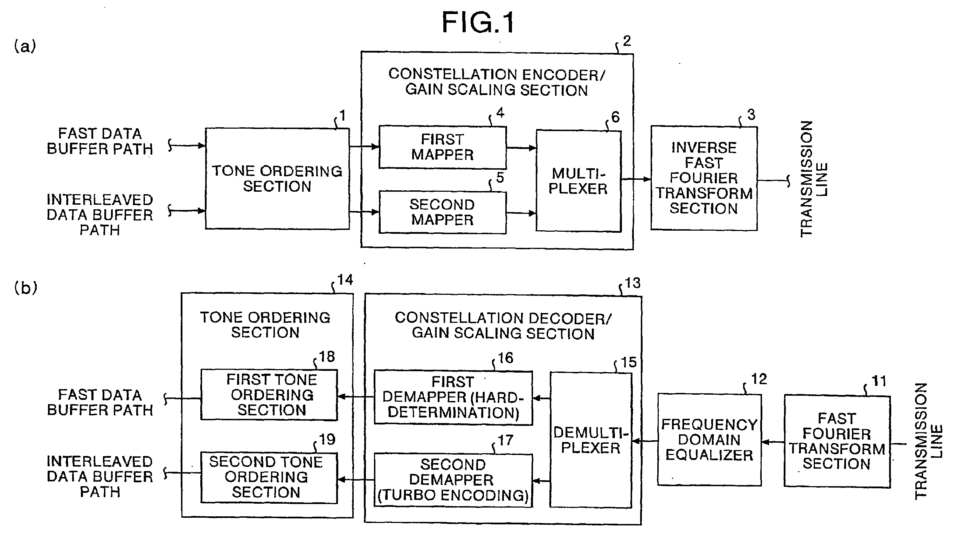

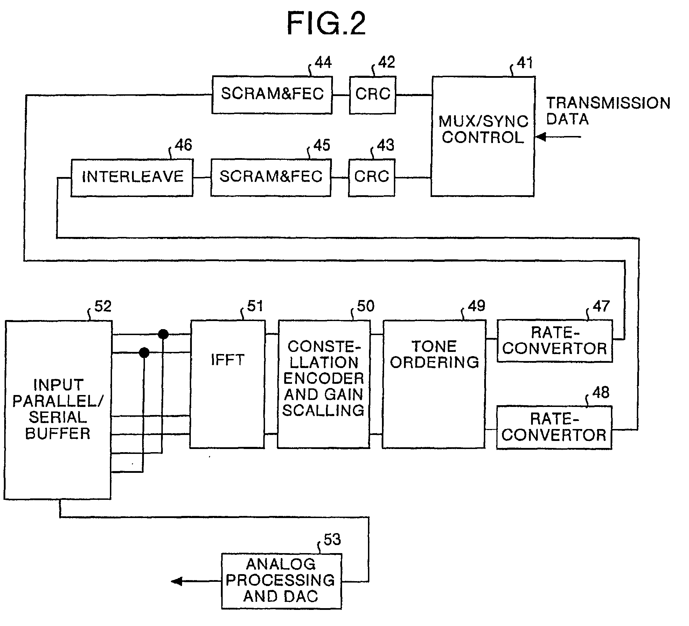

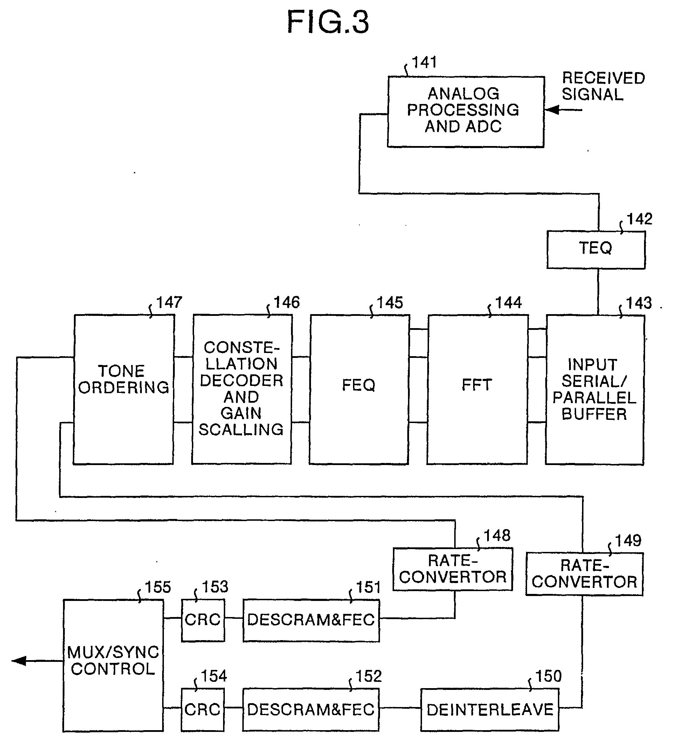

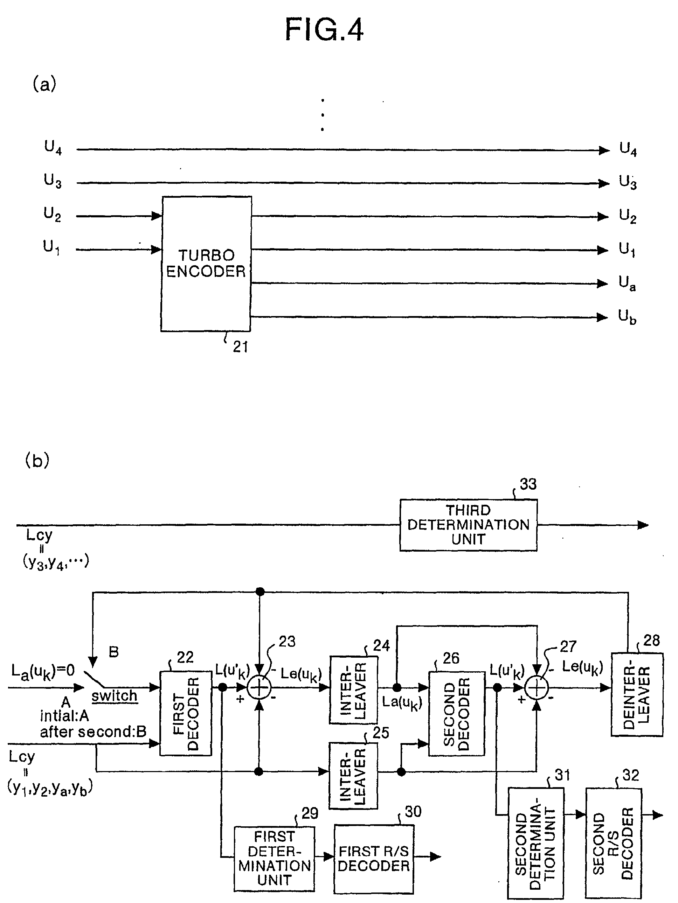

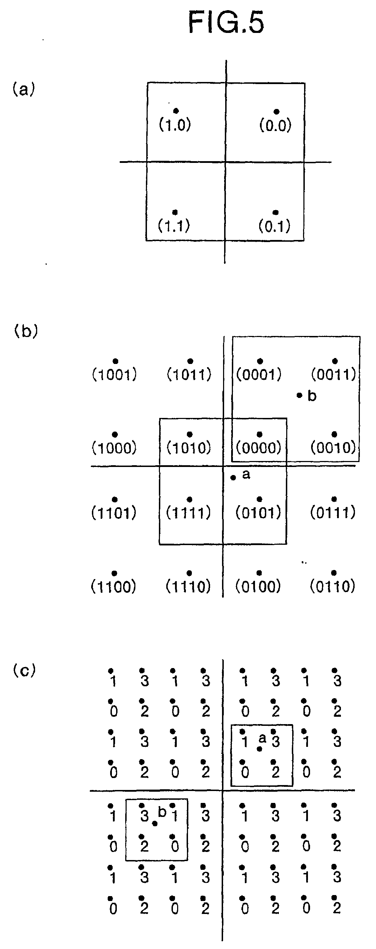

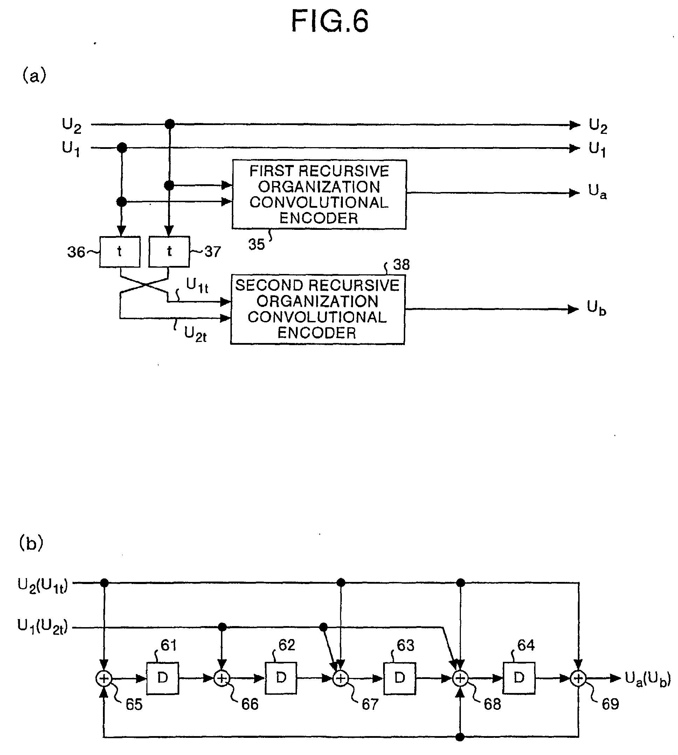

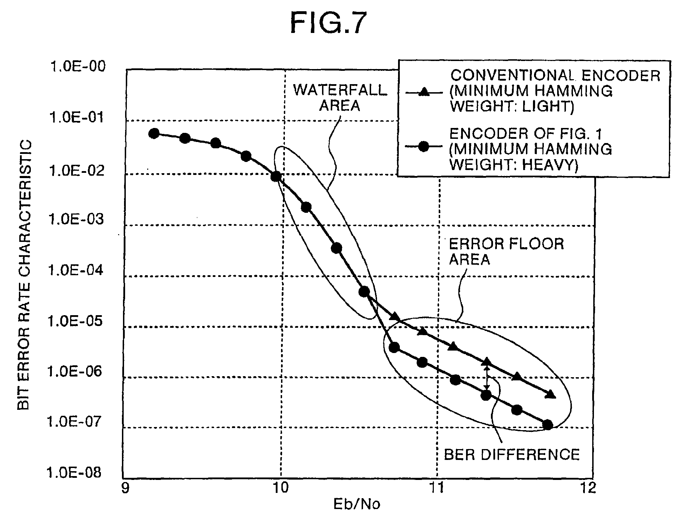

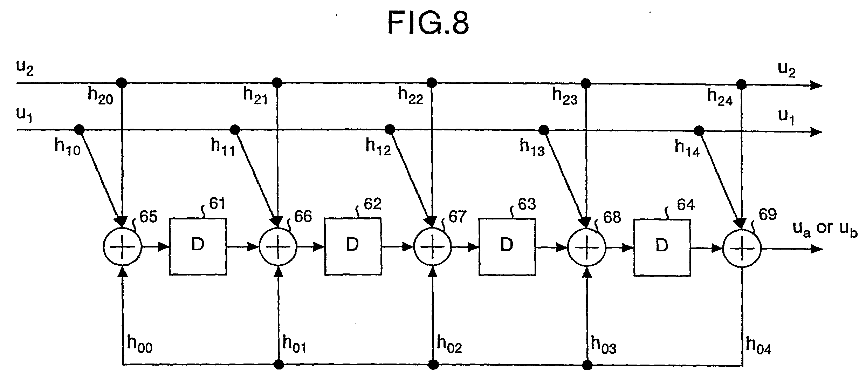

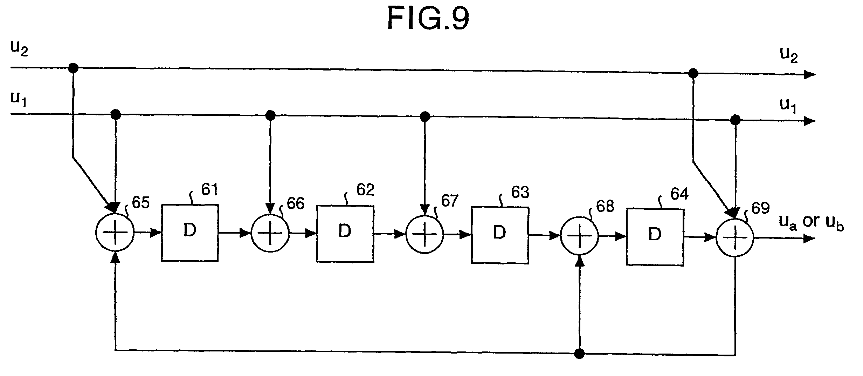

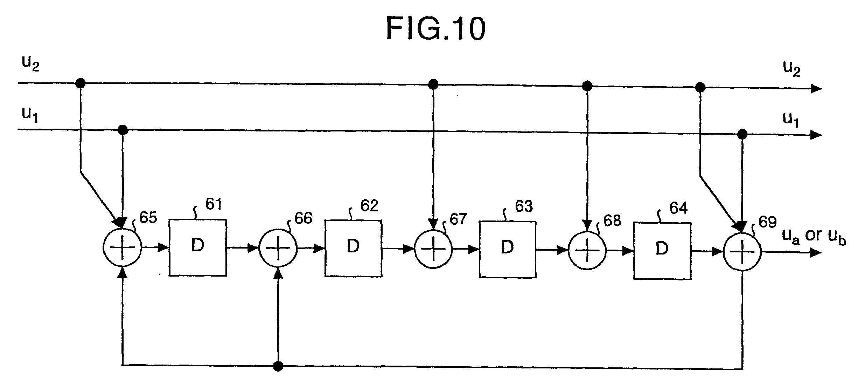

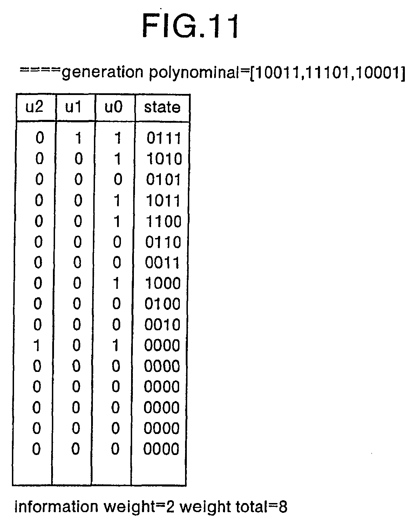

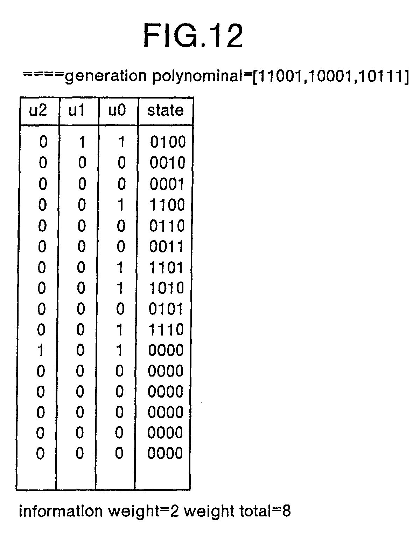

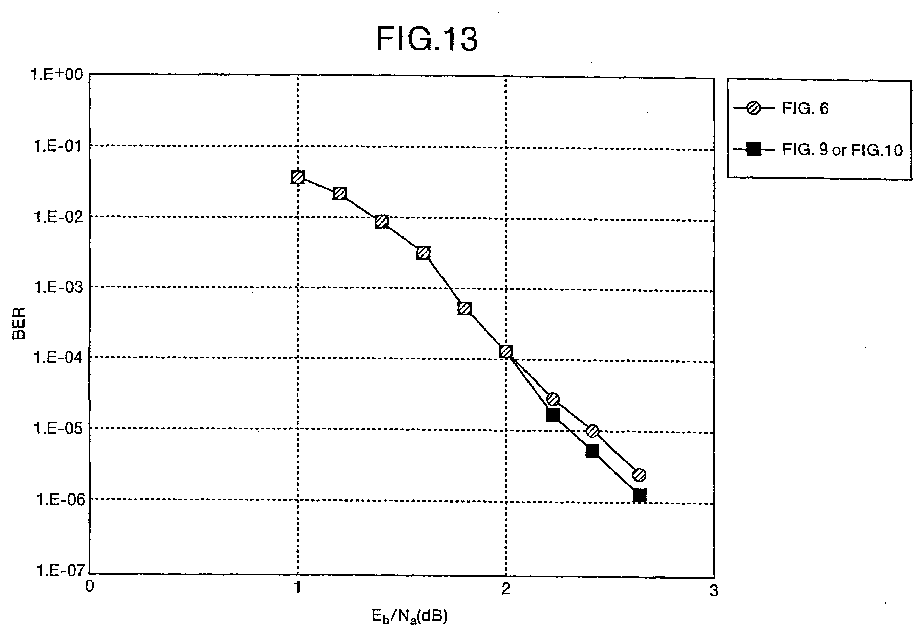

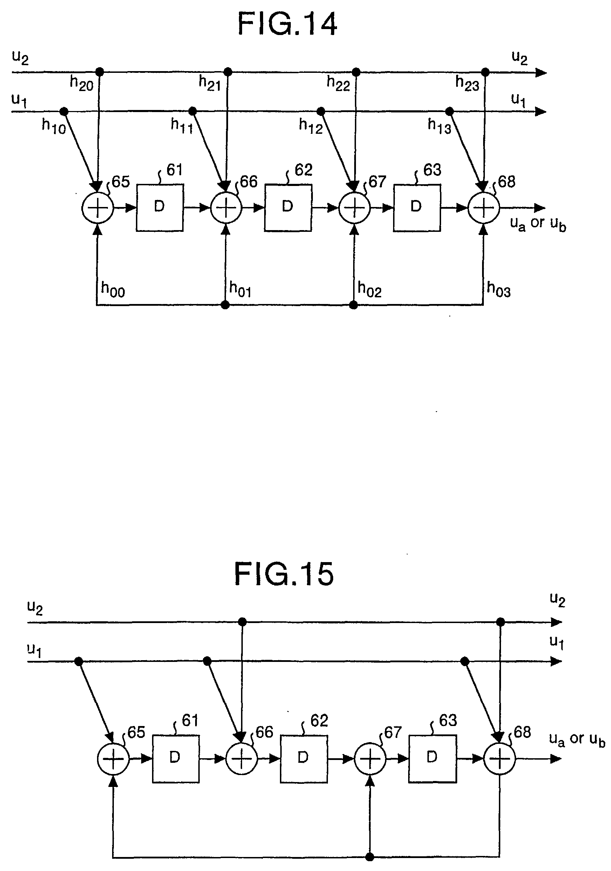

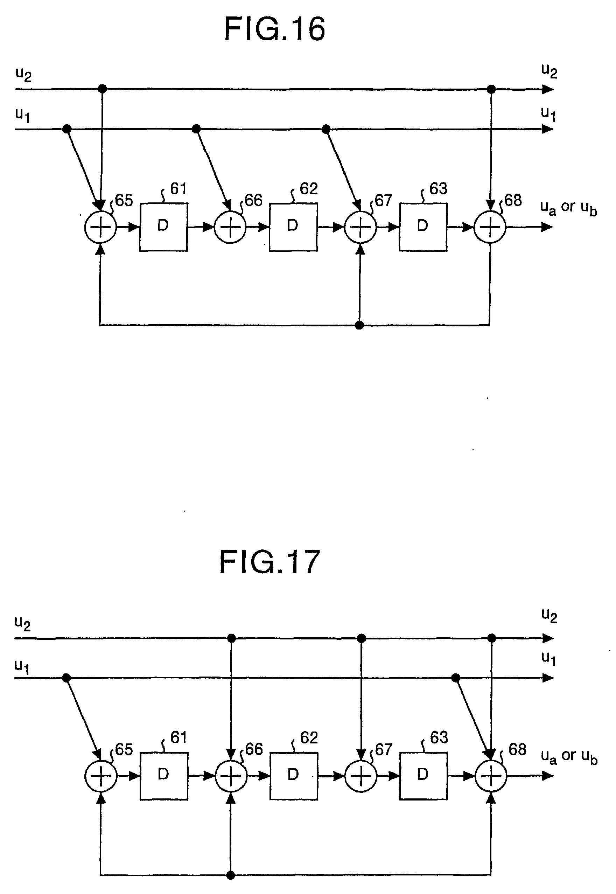

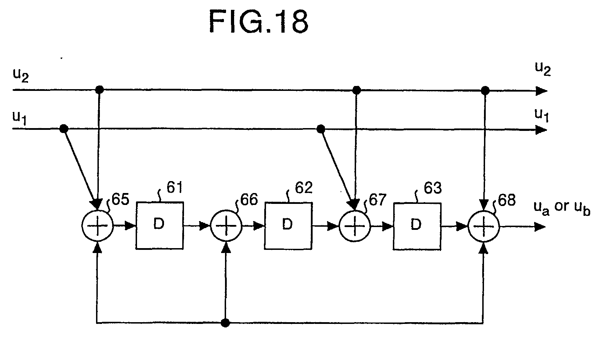

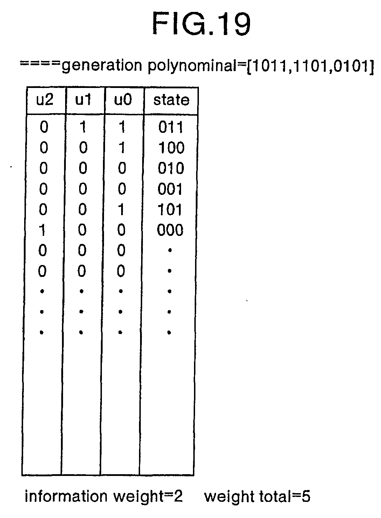

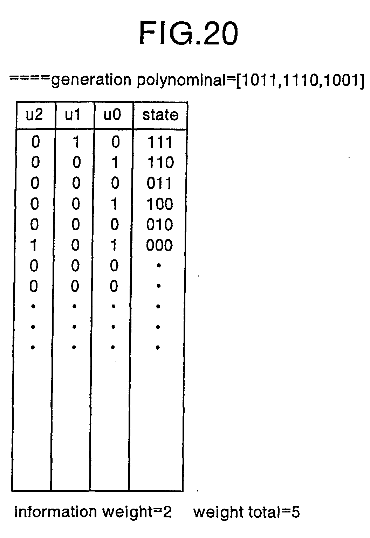

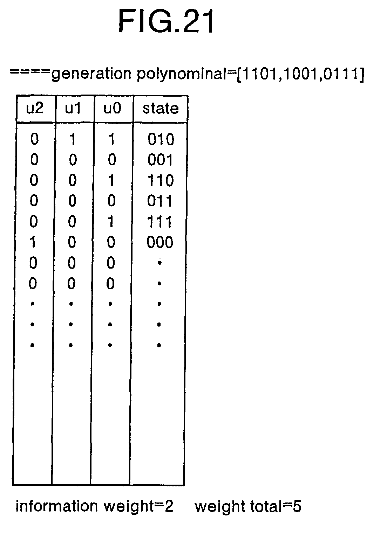

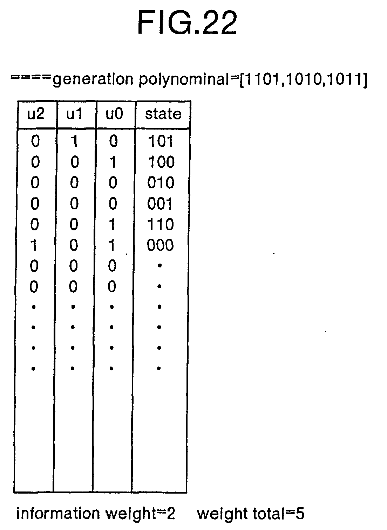

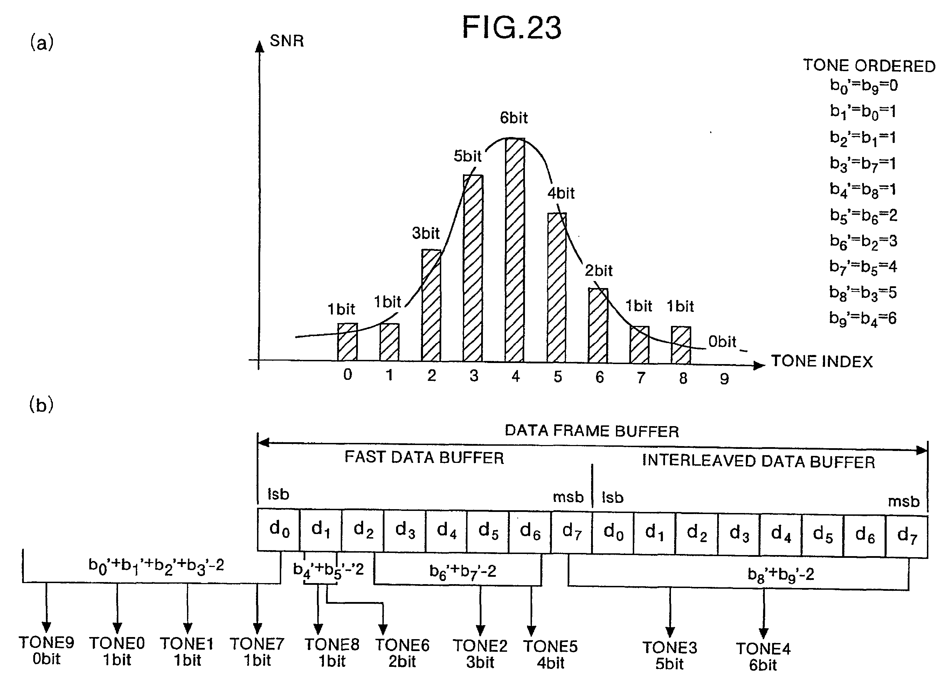

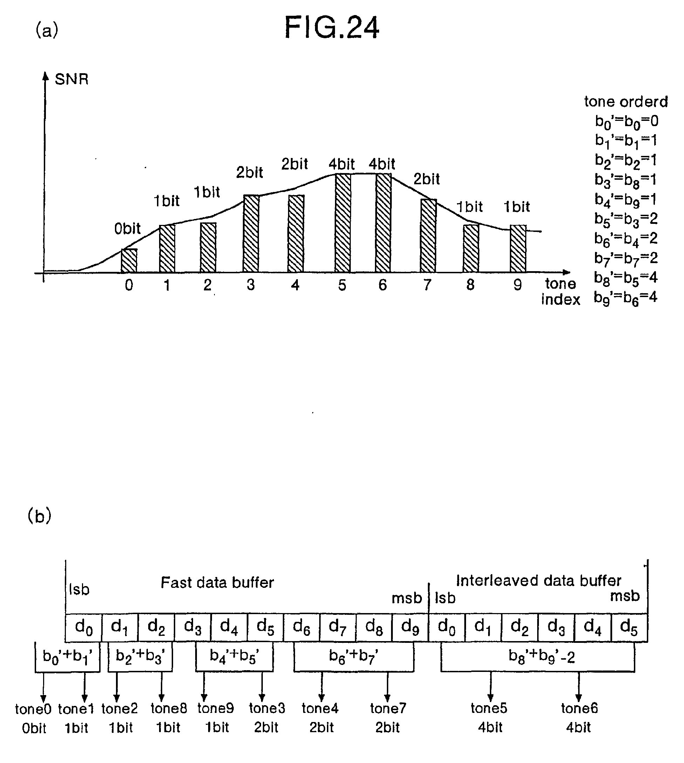

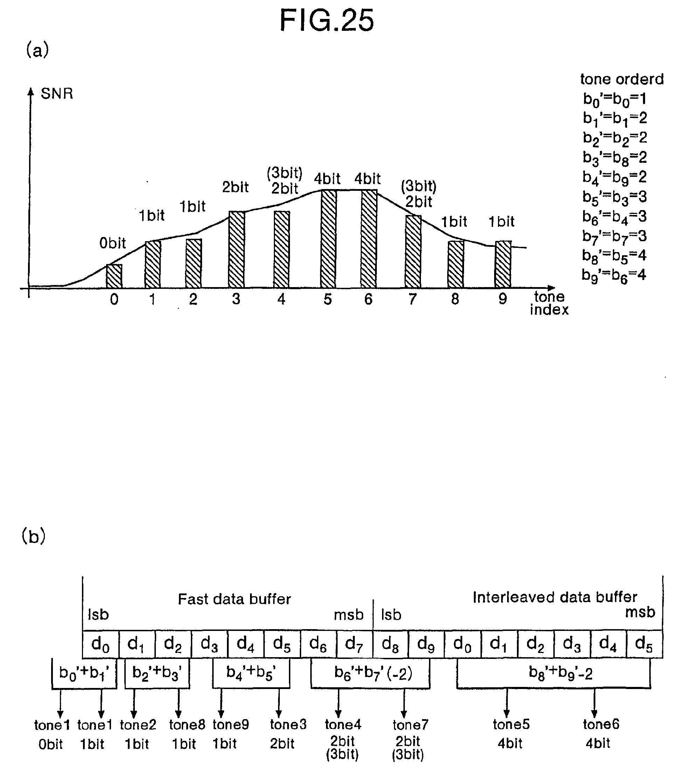

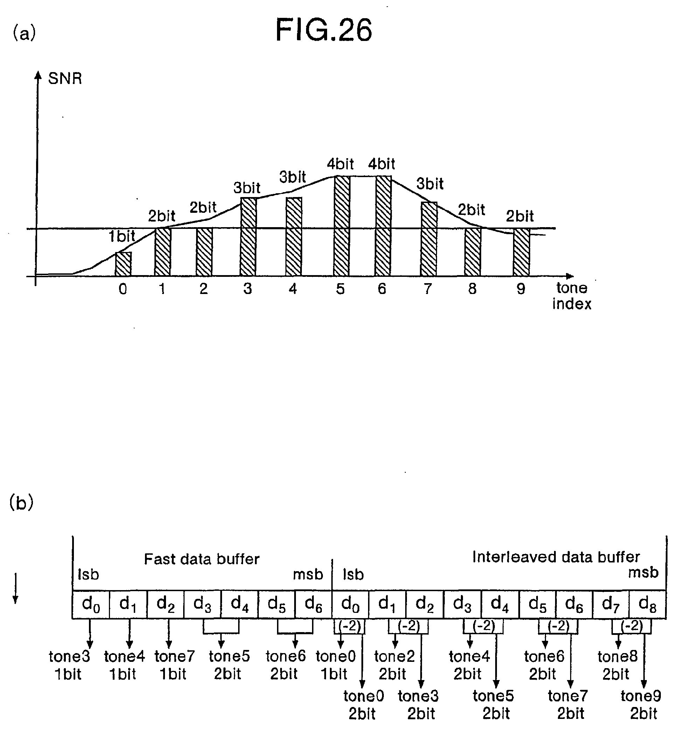

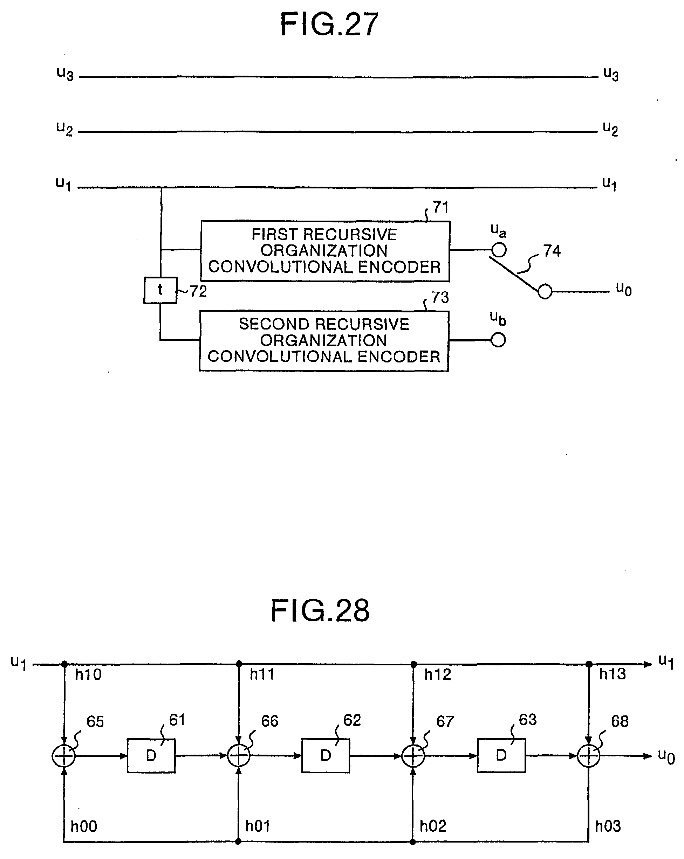

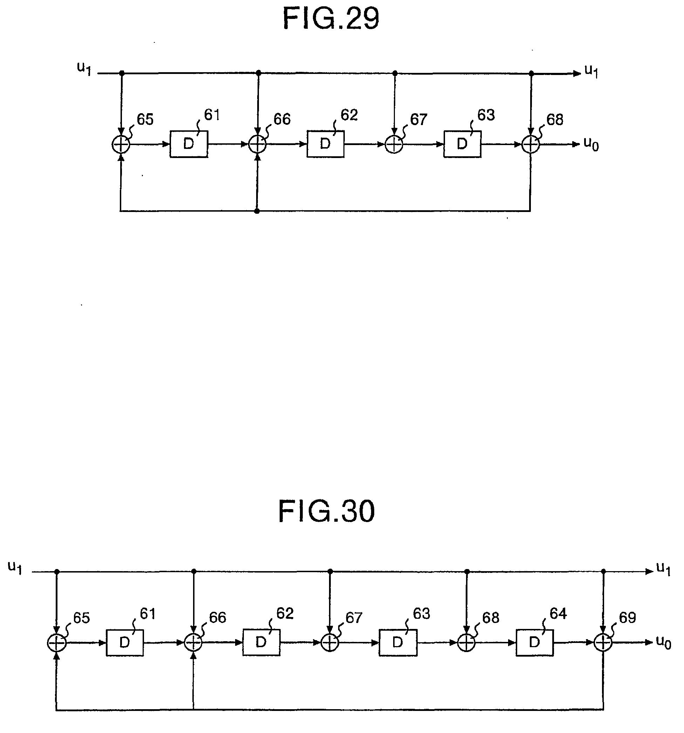

Fig. 1 is a block diagram showing the configuration of a first embodiment a communication device according to the present invention; Fig. 2 is a block diagram showing the configuration of the transmission system of the communication device according to the present invention; Fig. 3 is a block diagram showing the configuration of the receiving system of the communication device according to the present invention; Fig. 4 is a block diagram showing the configurations of an encoder and a decoder employed in the communication device according to the present invention; Fig. 5 shows the arrangement of signal points in various types of digital modulation systems; Fig. 6 is a block diagram showing the configuration of a turbo encoder; Fig. 7 shows BER characteristic in a case where transmission data is decoded using the turbo encoder of the present invention and BER characteristic in a case where transmission data is decoded using a conventional turbo encoder; Fig. 8 shows one example of the connection of a recursive organization convolutional encoder on the premise of a constraint length: 5 and the number of memories: 4; Fig. 9 shows an optimum recursive organization convolutional encoder obtained by a predetermined search method; Fig. 10 shows an optimum recursive organization convolutional encoder obtained by a predetermined search method; Fig. 11 shows the distance: de between the bits `1' and a total weight of a self-terminating pattern for the recursive organization convolutional encoder shown in Fig. 9; Fig. 12 shows the distance: de between the bits `1' and a total weight of a self-terminating pattern for the recursive organization convolutional encoder shown in Fig. 10; Fig. 13 shows BER characteristic in a case where transmission data is decoded using the turbo encoder shown in Fig. 6 and BER characteristic in a case where transmission data is decoded using a turbo encoder adopting the recursive organization convolutional encoder shown in Fig. 9 or Fig. 10; Fig. 14 shows one example of the connection of the recursive organization convolutional encoder on the premise of a constraint length: 4 and the number of memories: 3; Fig. 15 shows an optimum recursive organization convolutional encoder obtained by a predetermined search method; Fig. 16 shows an optimum recursive organization convolutional encoder obtained by a predetermined search method; Fig. 17 shows an optimum recursive organization convolutional encoder obtained by a predetermined search method; Fig. 18 shows an optimum recursive organization convolutional encoder obtained by a predetermined search method; Fig. 19 shows the distance: de between the bits `1' and a total weight of a self-terminating pattern for the recursive organization convolutional encoder shown in Fig. 15; Fig. 20 shows the distance: de between the bits `1' and a total weight of a self-terminating pattern for the recursive organization convolutional encoder shown in Fig. 16; Fig. 21 shows the distance: de between the bits `1' and a total weight of a self-terminating pattern for the recursive organization convolutional encoder shown in Fig. 17; Fig. 22 shows the distance: de between the bits `1' and a total weight of a self-terminating pattern for the recursive organization convolutional encoder shown in Fig. 18; Fig. 23 shows one example of a tone ordering processing; Fig. 24 shows the tone ordering processing in the first embodiment; Fig. 25 shows the tone ordering processing in a second embodiment; Fig. 26 shows the tone ordering processing in a third embodiment; Fig. 27 is a block diagram showing the configuration of a turbo encoder in a fourth embodiment; Fig. 28 shows a method for expressing the recursive organization convolutional encoder in a case on the premise of a constraint length: 4 and the number of memories: 3; Fig. 29 is a block diagram showing the configuration of an optimum recursive organization convolutional encoder obtained by a search method in the fourth embodiment; Fig. 30 is a block diagram showing the configuration of an optimum recursive organization convolutional encoder obtained by a search method in the fourth embodiment; Fig. 31 is a block diagram showing the configuration of a conventional turbo encoder employed in a receiving system; Fig. 32 is a block diagram showing the configuration of a conventional turbo decoder employed in a receiving system; Fig. 33 shows the processing of an interleaver employed in the conventional turbo encoder; Fig. 34 shows the processing of an interleaver employed in the conventional turbo encoder; Fig. 36 shows BER characteristics in a case of employing the conventional turbo encoder and the conventional turbo decoder; Fig. 37 is a block diagram showing the configuration of a trellis encoder employed in a conventional communication device; and Fig. 38 shows a conventional tone ordering processing.

BEST MODES FOR CARRYING OUT THE INVENTION

Embodiments of a communication device according to the present invention will be described hereinafter in detail based on the drawings. It is noted that the present invention is not limited by these embodiments.

First embodiment

Fig. 1 is a block diagram showing the configuration of the first embodiment of a communication device according to the present invention. More specifically, Fig. 1 (a) is a block diagram of a transmitting end in this embodiment and Fig. 1(b) is a block diagram of a receiving end in this embodiment.

The communication device in this embodiment includes both the configuration of the transmitting end and that of the receiving end stated above and further has a highly accurate data error correction capability by a turbo encoder and a turbo decoder, thereby obtaining excellent transmission characteristic for data communication and voice communication. While the communication device includes the both configurations for the convenience of description in this embodiment, it is also possible to assume the communication device as a transmitter including only the configuration of the transmitting end or as a receiver including only the configuration of the receiving end.

In the transmitting end shown in Fig. 1(a), for example, reference symbol 1 denotes a tone ordering section, 2 denotes a constellation encoder/gain scaling section, 3 denotes an inverse fast Fourier transform section (IFFT), 4 denotes the first mapper for a fast data buffer path, 5 denotes the second mapper for an interleaved data buffer path and 6 denotes a multiplexer.

In the receiving end shown in Fig. 1(b), on the other hand, reference 11 denotes a fast Fourier transform section (FFT), 12 denotes a frequency domain equalizer (FEQ), 13 denotes a constellation decoder/gain scaling section, 14 denotes a tone ordering section, 15 denotes a demultiplexer, 16 denotes the first demapper for the first data buffer path, 17 denotes the second demapper for the interleaved data buffer, 18 denotes the first tone ordering section for the first data buffer path and 19 denotes the second tone ordering section for the interleaved data buffer.

Here, before starting the description of the operation of the transmitting end and that of the receiving end which are the features of the present invention, the basic operation of the communication device according to the present invention will be described briefly based on the drawings. A wire digital communication system for holding data communication employing a DMT (Discrete Multi Tone) modulation demodulation system is exemplified by an xDSL communication system such as an ADSL (Asymmetric Digital Subscriber Line) communication system which holds high-speed digital communication at several megabits/second using a telephone line already provided or an HDSL (high-bit-rate Digital Subscriber Line) communication system. This system is standardized by ANSI T1.413 or the like. In the following description of this embodiment, a communication device applicable to the above-stated ADSL communication system will be described.

Fig. 2 is a block diagram showing the overall configuration of the transmission system of the communication device according to the present invention. In Fig. 2, in the transmission system, transmission data is multiplexed by a multiplex/sync control section (corresponding to MUX/SYNC CONTROL in Fig. 2) 41, an error detection code is added to the multiplexed transmission data by cyclic redundancy checkers (corresponding to CRC's: Cyclic redundancy check) 42 and 43, and an FEC code is added to the data and the resultant data is scrambled by forward error correction sections (corresponding to SCRAM&FEC's) 44 and 45.

It is noted that there are two paths from the multiplex/sync control section 41 to a tone ordering section 49; one is an interleaved data buffer (Interleaved Data Buffer) path including an interleaver (INTERLEAVE) 46 and the other is a fast data buffer (Fast Data Buffer) path which does not include the interleaver. Here, the interleaved data buffer path in which an interleave processing is performed has more delay.

Thereafter, the transmission data is subjected to a rate conversion processing by rate-converters (corresponding to RATE-CONVERTER's) 47 and 48 and subjected to a tone ordering processing by a tone ordering section (corresponding to TONE ORDERING, and to the tone ordering section 1 shown in Fig. 1) 49. Based on the transmission data which has been tone-ordered, a constellation encoder/gain scaling (corresponding to CONSTELLATION AND GAIN SCALLING, and to the constellation encoder/gain scaling section 2 shown in Fig. 1) 50 generates constellation data and inverse fast Fourier transform section (corresponding to IFFT: Inverse Fast Fourier transform and to the inverse fast Fourier transform section 3) 51 conducts inverse fast Fourier transform to the constellation data thus generated.

Finally, the parallel data obtained by the Fourier transform is transformed into serial data by an input parallel/serial buffer (corresponding to INPUT PARALLEL/SERIAL BUFFER) 52, the digital waveform of the serial data is converted into an analog waveform by an analog processing/digital-analog converter (corresponding to ANALOG PROCESSING AND DAC) 53, a filtering processing is conducted to the converted data and then the resultant transmission data is transmitted onto a telephone line.

Fig. 3 is a block diagram showing the overall configuration of the receiving system of the communication device according to the present invention. In Fig. 3, in the receiving system, received data (transmission data stated above) is subjected to a filtering processing by an analog processing/analog-digital converter (corresponding to ANALOG PROCESSING AND ADC shown in Fig. 3) 141, the analog waveform of the data is converted into a digital waveform and the converted data is subjected to a processing such as a time domain adaptation processing by a time domain equalizer (corresponding to FEQ) 142.

The data for which the processing such as the time domain adaptation processing has been executed is transformed from serial data to parallel data by an input serial/parallel buffer (corresponding to INPUT SERIAL/PARALLEL BUFFER) 143, the parallel data is subjected to fast Fourier transform by a fast Fourier transform section (corresponding to FFT: Fast Fourier transform and to the fast Fourier transform section 11 shown in Fig. 1) 144, and then the resultant data is subjected to a processing such as a frequency domain adaptation processing by a frequency domain equalizer (corresponding to FEQ and to the frequency domain equalizer 12 shown in Fig. 1) 145.

The data for which the processing such as the frequency domain adaptation processing has been executed is transformed into serial data by a decoding processing (maximum likelihood decoding method) and a tone ordering processing performed by a constellation decoder/gain scaling section (corresponding to CONSTELLATION DECODER AND GAIN SCALING and to the constellation decoder/gain scaling section 13 shown in Fig. 1) 146 and a tone ordering section (corresponding to TONE ORDERING and to the tone ordering section 14 shown in Fig. 1) 147, respectively. Thereafter, the data is subjected to a rate conversion processing by rate converters (corresponding to RATE-CONVERTERS) 148 and 149, a deinterleave processing by a deinterleaver (corresponding to DEINTERLEAVE) 150, an FEC processing and descramble processing by forward error correction sections (corresponding to DESCRAM&FEC) 151 and 152, and a processing such as a cyclic redundancy check by cyclic redundancy checkers (corresponding to cyclic redundancy check) 153 and 154. Finally, received data is reproduced from a multiplex/sync control section (corresponding to MUX/SYNC CONTROL) 155.

In the communication device shown above, each of the receiving system and the transmission system has two paths. By separately using these two paths or simultaneously operating these two paths, it is possible to realize data communication having a little transmission delay and a high rate.

Now, the operation of an encoder (transmission system) and that of a decoder (receiving system) in this embodiment will be described with reference to the drawings. Fig. 4 is a block diagram showing the configurations of an encoder (turbo encoder) and a decoder (a combination of a turbo decoder, a soft determination unit and an R/S (Reed-Solomon code) decoder) employed in the communication device according to the present invention. More specifically, Fig. 4 (a) is a block diagram of the encoder in this embodiment, and Fig. 4(b) is a block diagram of the decoder in this embodiment.

In the encoder shown in Fig. 4(a), for example, reference symbol 21 denotes a turbo encoder capable of exhibiting a performance close to the Shannon limit by adopting, as error correction codes, turbo codes. The turbo encoder 21 outputs, for example, two information bits and two redundant bits when two information bits are inputted. Further, each of the redundant bits is generated so that the receiving end has a uniform correction capability to each information bit.

On the other hand, in the decoder shown in Fig. 4(b), reference symbol 22 denotes the first decoder calculating a logarithmic likelihood ratio from received signals: Lcy (corresponding to received signals: $y_2$, $y_1$ and $y_a$ to be described later), 23 and 27 denote adders, respectively, 24 and 25 denote interleavers, respectively, 26 denotes the second decoder calculating a logarithmic likelihood ratio from received signals Lcy (corresponding to received signals: $y_2$, $y_1$ and $y_b$ to be described later), 28 denotes a deinterleaver, 29 denotes the first determination unit determining the output of the first decoder 22 and outputting the estimated values of an original information bit sequence, 30 denotes the first R/S decoder decoding Reed-Solomon codes and outputting a more accurate information bit sequence, 31 denotes the second determination unit determining the output of the second decoder 26 and outputting the estimated values of the original information bit sequence, 32 denotes the second R/S decoder decoding the Reed-Solomon codes and outputting a more accurate information bit sequence, and 33 denotes the third determination unit soft-determining Lcy (corresponding to the received signals: $y_3$, $y_4$, ... to be described later) and outputting the estimated values of the original information bit sequence.

First, the operation of the encoder shown in Fig. 4 (a) will be described. In this embodiment, as multivalued quadrature amplitude modulation (QAM: Quadrature Amplitude Modulation), 16QAM system, for example, is adopted. Also, the encoder in this embodiment, unlike the conventional technique for executing turbo encoding to all input data (four bits), executes turbo encoding only to input data of lower two bits and the input data of the remaining higher two bits are outputted as they are.

Here, the reason for executing turbo encoding only to the input data of lower two bits will be described. Fig. 5 shows the arrangement of signal points for various types of digital modulation systems. More specifically, Fig. 5 (a) shows the arrangement of signal points of a quadrature PSK (Phase Shift Keying) system, Fig. 5(b) shows the arrangement of signal points of a 16QAM system and Fig. 5 (c) shows the arrangement of signal points of a 64QAM system.

In the signal point arrangements of all the above-stated modulation systems, if a received signal point is at a position of a orb, the receiving end normally estimates the most likely data as an information bit sequence (transmission data) by soft-determination. Namely, the receiving end determines a signal point shortest to the received signal point as transmission data. At this moment, however, if attention is paid to, for example, the signal points a and b shown in Fig. 5, it is seen that the lower two bits of respective four points closest to the received signal point are (0, 0), (0, 1), (1, 0) and (1, 1) in all cases (corresponding to Fig. 5(a), (b) and (c)). In this embodiment, therefore, the lower two bits of the respective four signal points (i.e., four points having the shortest distances from the respective signal points) the characteristics of which points are highly likely deteriorated are subjected to turbo encoding having an excellent error correction capability and to soft-determination by the receiving end. On the other hand, the remaining higher bits which are less likely deteriorated are outputted as they are and subjected to hard-determination by the receiving end.

By doing so, in this embodiment, characteristics, which are likely to be deteriorated as the number of values increases, can be improved. Moreover, since only the lower two bits of the transmission signals are subjected to turbo encoding, it is possible to greatly reduce the quantity of operation compared with the conventional technique (see Fig. 31) intended to turbo-encode all the bits.

Next, one example of the operation of the turbo encoder 21 shown in Fig. 4(a) which turbo-encodes the inputted transmission data of the lower two bits: $u_1$ and $u_2$ will be described. By way of example, Fig. 6 is a block diagram showing an example of the configuration of the turbo encoder 21. More specifically, Fig. 6(a) is a block diagram of the turbo encoder and Fig. 6(b) is a block diagram showing one example of the circuit configuration of a recursive organization convolutional encoder. While the recursive organization convolutional encoder having the configuration shown in Fig. 6(b) is employed herein, the present invention is not limited thereto but the recursive organization convolutional encoder which is the same as the conventional encoder or the other known recursive organization convolutional encoder may be employed.

In Fig. 6(a), reference symbol 35 denotes the first recursive organization convolutional encoder convolutional-encoding the transmission data: $u_1$ and $u_2$ corresponding to an information bit sequence and outputting redundant data: $u_a$, 36 and 37 denote interleavers, respectively, and 38 denotes the second recursive organization convolutional encoder convolutional-encoding interleaved data $u_{1t}$ and $u_{2t}$ and outputting redundant data] $u_b$. The turbo encoder 21 simultaneously outputs the transmission data: $u_1$ and $u_2$, the redundant data: $u_a$ as a result of encoding the transmission data: $u_1$ and $u_2$ by the processing of the first recursive organization convolutional encoder 35, and the redundant data: $u_b$ (different in time from the other data) obtained by encoding the interleaved data: $u_{1t}$ and $u_{2t}$ by the processing of the second recursive organization convolutional encoder 38.

Further, in the recursive organization convolutional encoder shown in Fig. 6(b), reference symbols 61, 62, 63 and 64 denote delay devices and 65, 66, 67, 68 and 69 denote adders, respectively. In this recursive organization convolutional encoder, the adder 65 in the first stage adds the inputted transmission data: $u_2$ (or data: $u_{1t}$) and the fed-back redundant data: $u_a$ (or redundant data $u_b$) together and outputs the addition result, the adder 66 in the second stage adds the inputted transmission data: $u_1$ (or data: $u_{2t}$) and the output of the delay device 61 together and outputs the addition result, the adder 67 in the third stage adds the inputted transmission data: $u_1$ (or data: $u_{2t}$), the transmission data $u_2$ (or data: $u_{1t}$) and the output of the delay device 62 together and outputs the addition result, the adder 68 in the fourth stage adds the inputted transmission data: $u_1$ (or data: $u_{2t}$), the transmission data: $u_2$ (or data: $u_{1t}$) , the output of the delay device 63 and the fed-back redundant data: $u_a$ (or redundant data: $u_b$) together and outputs the addition result, and the adder 69 in the final stage adds the inputted transmission data: $u_2$ (or data: $u_{1t}$) and the output of the delay device 64 together and finally outputs the redundant data: $u_a$ (or redundant data: $u_b$) .

Further, the turbo encoder 21 prevents the weights of the respective redundant bits from being deviated so that the estimation accuracy of the transmission data: $u_1$ and $u_2$ on the receiving end employing the redundant data: $u_a$ and $u_b$ become uniform. That is to say, to make the estimation accuracy of the transmission data: $u_1$ and $u_2$ uniform, the transmission data: $u_2$, for example, is inputted into the adders 65, 67, 68 and 69 (see Fig. 6 (b) ) in the first recursive organization convolutional encoder 35 and the interleaved data: $u_{2t}$ is inputted into the adders 66 to 68 in the second recursive organization convolutional encoder 38. On the other hand, the transmission data: $u_1$ is inputted into the adders 66 to 68 in the first recursive organization convolutional encoder 35 and the interleaved data: $u_{1t}$ is inputted into the adders 65, 67, 68 and 69 in the second recursive organization convolutional encoder 38. By doing so, the number of delay devices through which the data is passed until the data is outputted is made equal between the transmission data : $u_1$ sequence and the transmission data : $u_2$ sequence.

In this way, if the encoder shown in Fig. 4(a) is employed, it is possible to improve the error correction capability for correcting burst data, which is the effect of interleave. Moreover, by changing the input of the transmission data: $u_1$ sequence and the input of the transmission data: $u_2$ sequence between the first recursive organization convolutional encoder 35 and the second recursive organization convolutional encoder 38, it is possible to make the estimation accuracies of the transmission data: $u_1$ and $u_2$ on the receiving end uniform.

Next, the operation of the decoder shown in Fig. 4 (b) will be described. In this embodiment, description will be given to a case where the 16QAM system is adopted as the multivalued quadrature amplitude modulation (QAM). Also, the decoder in this embodiment executes turbo-decoding to the lower two bits of the received data to estimate original transmission data by soft-determination, and hard-determines the other higher bits thereof in the third determination device 33 to thereby estimate the original transmission data. It is noted, however, that the received signals: Lcy: $y_4$, $y_3$, $y_2$, $y_1$, $y_a$ and $y_b$ are signals which had influences of the noise and fading of the transmission path on the transmitting-end outputs: $u_4$, $u_3$, $u_2$, $u_1$, $u_a$ and $u_b$, respectively.

First, when the turbo decoder receives the received signals Lcy: $y_2$, $y_1$, $y_a$ and $y_b$, the first decoder 22 extracts the received signals: Lcy: $y_2$, $y_1$ and $y_a$ and calculates the logarithmic likelihood ratios: $L(u_{1k}')$ and $L(u_{2k}')$ (where k represents time) of information bits (corresponding to original transmission data: $u_{1k}$ and $u_{2k}$) : $u_{1k}'$ and $u_{2k}'$ estimated from these received signals. That is, the first decoder 22 obtains the ratio of a probability in which $u_{2k}$ is 1 to a probability in which $u_{2k}$ is 0 and the ratio of a probability in which $u_{1k}$ is 1 to a probability in which $u_{1k}$ is 0. In the following description, $u_{1k}$ and $u_{2k}$ will be simply referred to as $u_k$ and $u_{1k}'$ and $u_{2k}'$ will be simply referred to as $u_k'$

It is noted, however, that in Fig. 4(b), symbol $Le(u_k)$ denotes external information and symbol $La (u_k)$ denotes

prior information which is external information prior to Le ($u_k$) Also, as the decoder calculating logarithmic likelihood ratios, the well-known maximum a posteriori probability decoder (MAP algorithm: Maximum A-Posteriori) is often employed. Alternatively, a well-known Viterbi decoder, for example, may be employed.

Next, the adder 23 calculates external information: Le($u_k$) on the second decoder 26 from the logarithmic likelihood ratio as a result of the above-stated calculation. It is noted that since no prior information is obtained in the first decoding, La($u_k$) = 0.

Next, the interleavers 24 and 25 rearranges the received signals Lcy and the external information: Le($u_k$) . The second decoder 26 calculates the logarithmic likelihood ratio: L($u_k'$ ) based on the received signals Lcy and the prior information: La($u_k$) calculated in advance as in the case of the first decoder 22.

Thereafter, the adder 27 calculates the external information: Le($u_k$) as in the case of the adder 23. At this moment, the external information rearranged by the deinterleaver 28 is fed back, as the prior information: La ($u_k$) , to the first decoder 22.

By iteratively executing the above-stated processings a predetermined number of times (iteration times), the turbo decoder calculates a more accurate logarithmic likelihood ratio. The first determination unit 29 and the second determination unit 31 determine signals based on this logarithmic likelihood ratio and estimate original transmission data. To be specific, if the logarithmic likelihood ration is, for example, "L($u_k'$) > 0", it is determined that the estimated information bit: $u_k'$ is 1 and if "L($u_k'$) $\leq$ 0", it is determined that the estimated information bit: $u_k'$ is 0. The received signals Lcy: $y_3$, $y_4$, ... received simultaneously are subjected to hard-determination using the third determination device 33.

Finally, the first R/S decoder 30 and the second R/S decoder 32 conduct error checking using Reed-Solomon codes by a predetermined method. When it is determined that an estimated accuracy exceeds a specific criterion, the above-stated iterative processings are finished. Then, using the Reed-Solomon codes, each determination unit corrects the error of the estimated original transmission data to thereby output transmission data having a higher estimation accuracy.

An original transmission data estimation method by the first R/S decoder 30 and the second R/S decoder 32 will be described based on concrete examples. Here, three methods will be mentioned as the concrete examples. In the first method, whenever the original transmission data is estimated by the first determination unit 29 or the second determination unit 31, the corresponding first R/S decoder 30 or second R/S decoder 32 alternately conducts error checking. When one of the R/S decoders determines that "there is no error", the above-stated iterative processings by the turbo encoder are finished. Thereafter, the estimated original transmission data is subjected to error correction using the Reed-Solomon codes to thereby obtain transmission data having a higher estimation accuracy.

Also, in the second method, whenever the original transmission data is estimated by the first determination unit 29 or the second determination unit 31, the corresponding first R/S decoder 30 or second R/S decoder 32 alternately conducts error checking. When the both R/S decoders determine that "there is no error", the above-stated iterative processings by the turbo encoder is finished. Thereafter, the estimated original transmission data is subjected to error correction using the Reed-Solomon codes to thereby output transmission data having a higher estimation accuracy.

Further, the third method solves the problem that error correction is erroneously conducted if it is erroneously determined that "there is no error" and the iterative processings are not executed by the first and second methods . For example, in the third method, after iterative processings are executed, a preset, predetermined number of times and a bit error rate is reduced to a certain extent, the estimated original transmission data is subjected to error correction using the Reed-Solomon codes to thereby output transmission data having a higher estimation accuracy.

As can be understood from the above, in case of employing the decoder shown in Fig. 4(b), even if constellation increases as the number of values of the modulation system increases, it is possible to realize the reduction of the soft-determination processing having a large calculation quantity and good transmission characteristic by providing the turbo decoder conducting the soft-determination to the lower two bits of the received signals which characteristics are likely to be deteriorated and error correction using the Reed-Solomon codes and the determination units conducting the hard-determination to the other bits of the received signals.

Furthermore, by estimating the transmission data using the first R/S decoder 30 and the second R/S decoder 32, it is possible to reduce the iteration times and to thereby further reduce the soft-determination processing having a large calculation quantity and processing time required for the soft-determination. It is generally known that on a transmission path in which a mixture of random errors and burst errors exist can obtain excellent transmission characteristic by combining R-S codes (Reed-Solomon) conducting error correction in units of symbols, the other known error correction codes and the like.

Next, BER (bit error rate) characteristic in a case where transmission data is decoded using the turbo encoder shown in Fig. 6 described above will be compared with BER characteristic in a case where transmission data is decoded using the conventional turbo encoder shown in Fig. 31. Fig. 7 shows the both BER characteristics. If the performances of turbo codes are determined using the BER, for example, the turbo encoder shown in Fig. 6 is low in bit error rate than the conventional encoder in a high $E_b/N_o$ area, i.e., an error floor area. The comparison result shown in Fig. 7 demonstrates that the turbo encoder shown in Fig. 6 having the low BER characteristic in the error floor area is obviously superior in performance to the conventional technique shown in Fig. 31.

In the description which has been given so far, the decoding characteristic of the receiving end is improved on the premise that the communication device adopts the turbo encoder, as shown in Fig. 6, expressed as:

$$g = [h_0, h_1, h_2]$$

$$= [10011, 01110, 10111] \tag{5}$$

(the expression of (5) will be described later), and the configuration in which, for example, at least one of the two information bit sequences inputted into this turbo encoder is inputted into the adder in the final stage. In the description to be given hereinafter, BER characteristic is further improved by using a turbo encoder which adopts a recursive organization convolutional encoder having a different configuration from that described above.

Now, a method for searching an optimum recursive organization convolutional encoder in this embodiment will be described. Here, an encoder having a constraint length: 5 (the number of adders) and the number of memories: 4 is assumed as one example of the recursive organization convolutional encoder. First, to search an optimum recursive organization convolutional encoder, the connection patterns of all the recursive organization convolutional encoders which encoder may possibly have if information bits: $u_1$ and $u_2$ are inputted and recursive organization convolutional encoders satisfying optimum conditions below are detected.

Fig. 8 shows a method for expressing the recursive organization convolutional encoder in a case on the premise of a constraint length: 5 and the number of memories: 4. For example, if the information bits: $u_1$ and $u_2$ are inputted into all adders and the redundant bit: $u_a$ (or $u_b$) is fed back to the respective adders other than that in the final stage, then the encoder can be expressed by a equation (6) .

$$g = [h_0, h_1, h_2]$$

$$= [11111, 11111, 11111] \tag{6}$$

In addition, the optimum conditions for searching the recursive organization convolutional encoder can be expressed as follows:

(1) A pattern in which a block length is L, an input weight is 2, and the distance: de between two bits `1' of a self-terminating pattern (in a state in which the delay devices 61, 62, 63 and 64 are all 0) becomes a maximum (e.g., distance de = 10).
To be specific, the frequency of the occurrence of self-terminating patterns:

$$K = L/de \text{ (figures after the}$$

$$\text{decimal point are rounded down)} \tag{7}$$

becomes a minimum; and
(2) A pattern in which a total weight becomes a maximum in the above-stated pattern (e.g., total weight = 8).

Figs. 9 and 10 show optimum recursive organization convolutional encoders obtained by the search method in this embodiment. In a case on the premise of a constraint length: 5 and the number of memories: 4, the recursive organization convolutional encoders each having the distance de = 10 and total weight = 8 (see Figs. 11 and 12 to be described later) as shown in Figs. 9 and 10 satisfy the above-stated optimum conditions.

To be specific, Fig. 9 shows the recursive organization convolutional encoder expressed as:

$$g = [h_0, h_1, h_2]$$

$$= [10011, 11101, 10001] \tag{8},$$

and Fig. 10 shows the recursive organization convolutional encoder expressed as:

$$g = [h_0, h_1, h_2]$$

$$= [11001, 10001, 10111] \tag{9}$$

Figs. 11 and 12 respectively show the self-terminating patterns and total weights of the recursive organization convolutional encoders, shown in Figs. 9 and 10, satisfying the above-stated optimum conditions.

Fig. 13 shows BER characteristic in a case where transmission data is decoded using the turbo encoder shown in Fig. 6 and BER characteristic in a case where transmission data is decoded using the turbo encoder adopting the recursive organization convolutional encoder shown in Fig. 9 or 10. If the performances of the turbo encoders are determined using, for example, the BERs thereof, the turbo encoder adopting the recursive organization convolutional encoder shown in Fig. 9 or 10 has a low bit error rate than that of the turbo encoder shown in Fig. 6 in the high $E_b/N_o$ area. That is to say, the comparison result shown in Fig. 13 demonstrates that the turbo encoder having a low ratio of high $E_b/N_o$ to BER characteristic in this embodiment is superior in performance to the turbo encoder shown in Fig. 6.

In this way, if the recursive organization convolutional encoder having a constraint length: 5 and the number of memories: 4 is assumed, the optimum recursive organization convolutional encoder is determined so that the distance: de between the bits `1' of the self-terminating pattern at a block length: L and an input weight: 2 becomes a maximum and a total weight becomes a maximum in the pattern having the maximum distance de.

It is noted that if the recursive organization convolutional encoder shown in Fig. 9 or 10 is employed in the turbo encoder, tail bits are processed as follows:

For example, in case of the recursive organization convolutional encoder shown in Fig. 9:

$$u_1^{(1)} = S0^{(0)} + S1^{(0)} + S3^{(0)}$$

$$u_2^{(1)} = S0^{(0)} + S2^{(0)}$$

$$u_1^{(2)} = S3^{(0)}$$

$$u_2^{(2)} = S0^{(0)} + S1^{(0)} \tag{10}$$

In case of the recursive organization convolutional encoder shown in Fig. 10:

$$u_1^{(1)} = S0^{(0)} + S1^{(0)} + S3^{(0)}$$

$$u_2^{(1)} = S2^{(0)}$$

$$u_1^{(2)} = 1^{(0)} + S2^{(0)} + S3^{(0)}$$

$$u_2^{(2)} = S1^{(0)} + S1^{(0)} \tag{11}$$

It is noted that symbol `+' shown in the equations represents exclusive disjunction.

On the other hand, with a view of providing an inexpensive communication device, it is also possible to employ a turbo encoder adopting a recursive organization convolutional encoder having a constraint length: 4 and the number of memories: 3. In that case, as in the case of the above, the connection patterns of all recursive organization convolutional encoders which the encoder may possibly have if information bits: $u_1$ and $u_2$ are inputted are searched and recursive organization convolutional encoders satisfying the above-stated optimum conditions are detected.

Fig. 14 shows a method for expressing a recursive organization convolutional encoder in a case on the premise of a constraint length: 4 and the number of memories: 3. For example, if the information bits: $u_1$ and $u_2$ are inputted into all adders and the redundant bit: $u_a$ (or $u_b$) is fed back to the respective adders other than that in the final stage, the recursive organization convolutional encoder can be expressed by a equation (14):

$$g = [h_0, h_1, h_2]$$

$$= [1111, 1111, 1111] \tag{14}$$

Figs. 15, 16, 17 and 18 show optimum recursive organization convolutional encoders obtained by the above-stated search methods (1) and (2). In a case on the premise of a constraint length: 4 and the number of memories: 3, the recursive organization convolutional encoders each having a distance de = 5 and a total weight = 5 (see Figs. 19 to 22 to be described later) as shown in Figs. 15 to 18 satisfy the above-stated optimum conditions.

To be specific, Fig. 15 shows the recursive organization convolutional encoder expressed as

$$g = [h_0, h_1, h_2]$$

$$= [1011, 1101, 0101] \tag{15},$$

Fig. 16 shows the recursive organization convolutional encoder expressed as

$$g = [h_0, h_1, h_2]$$

$$= [1011, 1110, 1001] \tag{16},$$

Fig. 17 shows the recursive organization convolutional encoder expressed as

$$g = [h_0, h_1, h_2]$$

$$= [1101, 1001, 0111] \tag{17},$$

and Fig. 18 shows the recursive organization convolutional encoder expressed as

$$g = [h_0, h_1, h_2]$$

$$= [1101, 1010, 1011] \tag{18}$$

Figs. 19, 20, 21 and 22 show the self-terminating patterns and total weights of the recursive organization convolutional encoders satisfying the above-stated optimum conditions and shown in Figs. 15 to 18.

In this way, even if the recursive organization convolutional encoder having a constraint length: 4 and the number of memories: 3 is assumed, the optimum recursive organization convolutional encoder is determined so that the distance: de between the bits `1' of the self-terminating pattern at a block length: L and an input weight: 2 becomes a maximum and a total weight becomes a maximum in the pattern having the maximum distance de.

It is noted that if the recursive organization convolutional encoder shown in Fig. 15, 17 or 18 is employed in the turbo encoder, tail bits are processed as follows:

For example, in case of the recursive organization convolutional encoder shown in Fig. 15:

$$u_1^{(1)} + u_2^{(1)} + u_2^{(2)} = S1^{(0)} + S2^{(0)}$$

$$u_2^{(1)} + u_1^{(2)} + u_2^{(2)} = S2^{(0)}$$

$$u_1^{(2)} + u_2^{(2)} = S0^{(0)} + S1^{(0)} + S2^{(0)} \tag{19}$$

In case of the recursive organization convolutional encoder shown in Fig. 16:

$$u_1^{(1)} + u_2^{(1)} + u_1^{(2)} = S1^{(0)} + S2^{(0)}$$

$$u_1^{(1)} + u_1^{(2)} = S2^{(0)}$$

$$u_2^{(1)} + u_1^{(2)} + u_2^{(2)} = S0^{(0)} + S1^{(0)} + S2^{(0)} \qquad (21)$$

In case of the recursive organization convolutional encoder shown in Fig. 18:

$$u_1^{(1)} + u_2^{(1)} + u_1^{(2)} = S1^{(0)}$$

$$u_2^{(1)} + u_2^{(2)} = S1^{(0)} + S2^{(0)}$$

$$u_2^{(1)} + u_1^{(2)} + u_2^{(2)} = S0^{(0)} + S2^{(0)} \qquad (22)$$

It is noted that symbol `+' shown in the equations represents exclusive disjunction.

So far, the configurations and operations of the encoder and the decoder in the communication device if turbo codes are applied to error correction control have been described. Next, the operation of the transmitting end (including the operation of the decoder) and the operation of the receiving end (including the operation of the decoder) which are the features of the present invention will be described. It is noted that the configurations shown in Fig. 4 already described above are used as the configurations of the encoder and the decoder. Also, the configuration shown in Fig. 6 (a) is employed as the configuration of the turbo encoder and any one of the configurations shown in Figs. 6(b), ,9,10 and 15 to 18 is applied to the configuration of the recursive organization convolutional encoder.

If data communication is held by the DMT modulation demodulation systemusing an existing transmission line such as a telephone line, for example, a transmitting end performs a tone ordering processing, i.e., a processing for allocating, to a plurality of tones (multi carriers) in preset frequency bands, transmission data having bits which the respective tones can transmit, respectively, based on the S/N ratio (signal-to-noise ratio) of the transmission path (which processing determines respective transmission rates).

Concretely, as shown in Fig. 23(a), for example, transmission data having bits are allocated to tone0 to tone9 with respective frequencies according to an S/N ratio, respectively. In this case, transmission data of 0 bit is allocated to tone9, transmission data of one bit is allocated to each of tone0, tone1, tone7 and tone8, transmission data of two bits is allocated to tone6, transmission data of three bits is allocated to tone2, transmission data of four bits is allocated to tone5, transmission data of five bits is allocated to tone3, and transmission data of six bits is allocated to tone4, and one frame is formed out of these 24 bits (information bits: 16 bits, redundant bits : 8 bits). It is noted that many bits are allocated to the respective tones compared with the frame buffers shown (the first data buffer and interleaved data buffer) because redundant bits necessary for error correction are added.

One frame of the transmission data subjected to the tone ordering processing is constituted as shown in, for example, Fig. 23 (b) . To be specific, the tones are arranged in the ascending order of the number of allocated bits, i. e., tone9 (b0'), tone0 (b1'), tone1 (b2'), tone7 (b3'), tone8 (b4'), tone6 (b5'), tone2 (b6'), tone5 (b7'), tone3 (b8') and tone4 (b9') are arranged in this order, and tone9, tone0, tone1 and tone7, tone8 and tone6, tone2 and tone5, and tone3 and tone4 are constituted as tone sets, respectively.

As can be seen, here, a tone set is formed out of two or four tones in the ascending order of the number of bits allocated by the tone ordering processing. Then, the above-stated turbo codes constituted out of at least three bits (in which case, information bits constitute one information bit sequence) are allocated to each tone set.

Thereafter, the data in the buffers constituted as shown in Fig. 23 is encoded for each tone set. First, if data0 of the first tone set (tone9, tone0, tone1, tone7) and dummy data d_dummy (since information bits constitute one information bit sequence) inputted into the terminals $u_1$ and $u_2$ of the turbo encoder 21, then two information bits ($u_1$, $u_2$) and two redundant bits ($u_a$, $u_b$), i.e., turbo codes of four bits are outputted. The added two bits correspond to these redundant bits. It is noted that since the information bit $u_2$ is dummy data, it is three bits of $u_1$, $u_a$ and $u_b$ that are actually encoded.

Next, if data d1 of the second tone set (tone8, tone6) and dummy data d_dummy are inputted into the terminals $u_1$ and $u_2$ of the turbo encoder 21, then two information bits ($u_1$, $u_2$) and two redundant bits ($u_a$, $u_b$), i.e., turbo codes of four bits are outputted. The added two bits correspond to these redundant bits. It is noted that since the information bit $u_2$ is dummy data, it is three bits of $u_1$, $u_a$ and $u_b$ that are actually encoded as in the case of the above.

Next, if data d2, d3, d4, d5 and d6 of the third tone set (tone2, tone5) are inputted into the terminals $u_1$ and $u_2$ of the turbo encoder 21 and terminals $u_4$, $u_5$, ..., then two information bits ($u_1$, $u_2$) and two redundant bits ($u_a$, $u_b$) , i.e., turbo codes of four bits and the other data of three bits ($u_3$, $u_4$, ...) are outputted. The added two bits correspond to these redundant bits.

Finally, if data d7, d0, d1, d2, d3, d4, d5, d6 and d7 of the fourth tone set (tone3, tone4) are inputted into the terminals $u_1$ and $u_2$ of the turbo encoder 21 and terminals $u_4$, $u_5$, ..., then two information bits ($u_1$, $u_2$) and two redundant bits ($u_a$, $u_b$) , i.e., turbo codes of four bits and the other data of seven bits ($u_3$, $u_4$, ...) are outputted. The added two bits correspond to these redundant bits.

As stated above, if the tone ordering processing based on the respective S/N ratios and the encoding processing are performed, transmission data is multiplexed for each frame. Further, the transmitting end conducts inverse fast Fourier transform (IFFT) to the multiplexed transmission data, converts the digital waveform of the data into an analog waveform by the D/A converter, and feeds the resultant data to the low-pass filter, thereby transmitting final transmission data onto the telephone line.

In this way, by forming each of tone sets out of two or four tones in the ascending order of the number of allocated bits and allocating turbo codes constituted out of at least three bits to each tone set, the communication device employing turbo codes can obtain useful, good transmission efficiency.

However, the above-stated communication method executing turbo encoding to all the tone sets has a disadvantage in that a little transmission delay cannot be realized, from the viewpoint of "realizing high-rate/high reliability data communication using an interleaved data buffer path and realizing a little transmission delay using fast data buffer". To be specific, since the interleaver (see Fig. 6(a)) in the turbo encoder 21 is required to store data having a block length of a certain degree (e.g., 8DMT symbol) in buffers, delay by as much as time required for storing the data occurs.

In this embodiment, therefore, a little transmission delay of the fast data buffer path is realized as shown in, for example, Fig. 1, by separating the processing in units of tones on the fast data buffer path and the interleaved data buffer path in the constellation encoder/gain scaling section 2, i.e., by not executing turbo encoding on the fast data buffer path.

Now, the operations of the transmitting end and the receiving end in this embodiment will be described in detail with reference to Figs. 1 and 24. If data communication is held by the DMT modulation demodulation system using an existing transmission line such as a telephone line, for example, the transmitting end performs a tone ordering processing, i.e., aprocessing for allocating, to a plurality of tones in preset frequency bands, transmission data having bits which the respective tones can transmit, respectively, based on the S/N ratio of the transmission path (which processing determines respective transmission rates).

As shown in Fig. 24 (a) , for example, transmission data having bits are allocated to tone0 to tone9 with respective frequencies according to an S/N ratio. In this embodiment, the fast data buffer secures the transmission rate to such an extent as to hold communication, i.e., if two lines on which communication can be held at a transmission rate of 64 kbps, the fast data buffer secures the number of bits with which a transmission rate of 128 kbps can be realized and the interleaved data buffer secures the remaining bits.

To be specific, as fast data buffer data, 0 bit is allocated to tone0, one bit is allocated to each of tone1, tone2, tone8 and tone9, and two bits are allocated to each of tone3, tone4 and tone7 . As interleaved data buffer data, four bits are allocated to each of tone5 and tone6. One frame is formed out of these 18 bits (information bits: 16 bits, redundant bits: 2 bits) . It is noted that many bits are allocated to the respective tones compared with the buffers shown (fast data buffer + interleaved data buffer) because redundant bits (two bits) necessary for turbo encoding are added.

Further, one frame of the transmission data subjected to the tone ordering processing is constituted as shown in, for example, Fig. 24(b). To be specific, the tones are arranged in the ascending order of the number of allocated bits, i.e., tone0 (b0'), tone1 (b1'), tone2 (b2'), tone8 (b3'), tone9 (b4'), tone3 (b5'), tone4 (b6'), tone7 (b7'), tone5 (b8') and tone6 (b9') are arranged in this order, and tone0 and tone1, tone2 and tone8, tone9 and tone3, tone4 and tone7, and tone5 and tone6 are constituted as tone sets, respectively.

Thereafter, the data in the buffers constituted as shown in Fig. 24 are outputted as they are on the fast data buffer path and encoded for each tone set on the interleaved data buffer path. First, if data d0 to d9 of the tone sets (tone0, tone1, tone2, tone8, tone9, tone3, tone4 and tone7) allocated to the fast data buffer are inputted into the first mapper 4, ten information bits are outputted as they are.

Next, if data d0, d1, d2, d3, d4 and d5 of the tone sets (tone5, tone6) allocated to the interleaved data buffer are inputted into the terminals $u_1$ and $u_2$ of the turbo encoder 21 and terminals $u_4$, $u_5$, ... in the second mapper 5, then two information bits ($u_1$, $u_2$) and two redundant bits ($u_a$, $u_b$), i.e., turbo codes of four bits and the other data of four bits ($u_3$, $u_4$, ...) are outputted. The added two bits correspond to these redundant bits.

The multiplexer 6 allocates the information bits from the first mapper 4 and the encoded data from the second mapper 5 to the respective tones (tone0 to tone9) in the order of reception, thereby generating constellation data. Since following operation is the same as that of the transmission system shown in Fig. 2, no description will be given thereto.

Meanwhile, on the receiving end, the demultiplexer 15 in the constellation decoder/gain scaling section 13 conducts a processing for allocating Fourier transformed frequency data to the tones on the fast data buffer path and the tones on the interleaved data buffer path based on the correspondence between the respective buffers and tones obtained by training.

The first demapper 16 hard-determines bits on the allocated tones on the fast data buffer path and outputs hard-determination data. Also, the second demapper 17 turbo-decodes (see the turbo decoder shown in Fig. 4(b)) lower two bits and hard-determines (see the third determination device 33 shown in Fig. 4(b)) the remaining higher bits on the respective allocated tones on the interleaved data buffer path and outputs these determination values.

Finally, the first tone ordering section 18 and the second tone ordering section 19 receive the above-stated respective outputs and execute tone ordering processings separately on the fast data buffer path and the interleaved data buffer path, respectively. Since the following operation is the same as the operation of the receiving system shown in Fig. 3, no description will be given thereto.

As can be understood fromthe above, in this embodiment, the transmitting end and the receiving end separate processings on the fast data buffer path and those on the interleaved data buffer in units of tones, respectively, no turbo encoding is executed on the fast data buffer path and turbo encoding is executed on the interleaved data buffer path. By doing so, if the interleaved data buffer path is used, it is possible to realize high-rate/high reliability data communication and if the fast data buffer path is used, time required for the interleave processing canbe shortened, so that a little transmission delay can be realized.

Second embodiment

In the first embodiment described above, both the transmitting end and the receiving end separate the processings on the fast data buffer path and those on the interleaved data buffer path in units of tones, respectively, thereby realizing a little transmission delay on the fast data buffer path.

In this embodiment, the number of bits allocated to each of the fast data buffer and the interleaved buffer is predetermined (in units of eight bits in this embodiment) . If a tone set spreads over the two buffers, for example, then the tone set is processed on the both paths, the bits corresponding to the fast data buffer are soft-determined and the bits corresponding to the interleaved data buffer are turbo-decoded, thereby realizing a little transmission delay on the fast data buffer path. Since configurations in this embodiment are the same as those in the first embodiment, the same reference symbols denote constituent elements and no description will be given thereto.

Now, the operation of a transmitting end and that of a receiving end in this embodiment will be described in detail with reference to Figs. 1 and 25. If data communication is held by the DMT modulation demodulation system using an existing transmission line such as a telephone line, for example, in the transmitting end, the tone ordering processing section 1 performs a tone ordering processing, i.e., a processing for allocating, to a plurality of tones in preset frequency bands, transmission data having bits which the respective tones can transmit, respectively, based on the S/N ratio of the transmission path (which processing determines respective transmission rates).

As shown in Fig. 25 (a) , for example, transmission data having bits are allocated to tone0 to tone9 with respective frequencies according to the S/N ratio of the transmission line. In this embodiment, the magnitude (the number of bits) of each of the fast data buffer and the interleaved data buffer is predetermined.

To be specific, as data for the fast data buffer, 0 bit is allocated to tone0, one bit is allocated to each of tone1, tone2, tone8 and tone9, and two bits are allocated to each of tone3, tone4 and tone7. As data for the interleaved data buffer, two bits are allocated to each of tone4 and tone7, and four bits are allocated to each of tone5 and tone6. One frame is formed out of these 18 bits (information bits: 16 bits, redundant bits: 2 bits). It is noted that many bits are allocated to the respective tones compared with the buffers shown (fast data buffer + interleaved data buffer) because redundant bits necessary for turbo encoding (2 bits) are added.

Further, one frame of the transmission data subjected to the tone ordering processing is constituted as shown in, for example, Fig. 25(b). To be specific, the tones are arranged in the ascending order of the number of allocated bits, i.e., tone0 (b0'), tone1 (b1'), tone2 (b2'), tone8 (b3'), tone9 (b4'), tone3 (b5'), tone4 (b6'), tone7 (b7'), tone5 (b8' ) and tone6 (b9') are arranged in this order, and tone0 and tone1, tone2 and tone8, tone9 and tone3, tone4 and tone7, and tone5 and tone6 are constituted as tone sets, respectively.

Thereafter, the data in the buffers constituted as shown in Fig. 25 are outputted as they are on the fast data buffer path and encoded for each tone set on the interleaved data buffer. First, if data d0 to d7 of the tone sets (tone0, tone1, tone2, tone8, tone9, tone3, tone4, tone7) allocated to the fast data buffer are inputted into the first mapper 4, eight information bits are outputted as they are.

Next, if data d6, d7, d0 and d1 of the tone set (tone 4 and tone7) allocated to the interleaved data buffer are inputted into the terminals $u_1$, $u_2$, $u_4$, $u_5$ of the turbo encoder 21 in the second mapper 5, two information bits ($u_1$, $u_2$) and two redundant bits ($u_a$, $u_b$) , i.e., turbo codes of four bits and the other data of two bits ($u_3$, $u_4$) are outputted. The

added two bits correspond to these redundant bits.

Finally, if data d2, d3, d4, d5, d6 and d7 of the tone set (tone5 and tone6) allocated to the interleaved data buffer are inputted into the terminals $u_1$ and $u_2$ of the turbo encoder 21 and terminals $u_4$, $u_5$, ... in the second mapper 5, then two information bits ($u_1$ $u_2$) and two redundant bits ($u_a$, $u_b$), i.e., turbo codes of four bits and the other data of four bits ($u_3$, $u_4$, ...) are outputted. The added two bits correspond to these redundant bits.

Then, the multiplexer 6 divides the information bits from the first mapper 4 and the encoded data from the second mapper 5 to the respective tones (tone0 to tone9) in the order of receipt, thereby generating constellation data. Since the following operation is the same as that of the receiving system shown in Fig. 2, no description will be given thereto.

Meanwhile, on the receiving end, the demultiplexer 15 in the constellation decoder/gain scaling section 13 conducts a processing for allocating Fourier transformed frequency data to the tones on the fast data buffer path and the tones on the interleaved data buffer path based on the correspondence between the respective buffers and tones obtained by training.

The first demapper 16 hard-determines bits on the allocated tones (tone0, tone1, tone2, tone8, tone9, tone3, tone4, tone7) on the fast data buffer path and outputs hard-determination data. Here, the hard-determination result is allocated to the bits: d0 to d7 corresponding to the fast data buffer, respectively. It is noted that the bits: d0 and d1 obtained if the tone set of tone4 and tone7 is hard-determined are deleted since the tone set constituted out of the tone4 and tone7 spreads over the both buffers.

Also, the second demapper 17 turbo-decodes (see the turbo decoder shown in Fig. 4(b)) lower two bits and hard-determines (see the third determination device 33 shown in Fig. 4(b)) the remaining higher bits on the respective allocated tone sets (tone4 and tone7, tone5 and tone6) on the interleaved data buffer path and outputs these determination values. Here, the turbo decoding result is allocated to the bits: d0 to d7 corresponding to the interleaved data buffer, respectively. It is noted that the bits: d0 and d1 obtained if the tone set of tone4 and tone7 is turbo-decoded are deleted since the tone set constituted out of the tone4 and tone7 spreads over the both buffers.

Finally, the first tone ordering section 18 and the second tone ordering section 19 receive the respective outputs stated above and execute tone ordering processings separately on the fast data buffer path and the interleaved data buffer path, respectively. Since the following operation is the same as that of the receiving system shown in Fig. 3, no description will be given thereto.

As can be seen, in this embodiment, the number of bits allocated to each of the fast data buffer and the interleaved data buffer is predetermined (in units of eight bits in this embodiment). If a tone set spreads over the two buffers, for example, then the tone set is processed on the both paths, the bits corresponding to the fast data buffer are hard-determined and the bits corresponding to the interleaved data buffer are turbo-decoded. By doing so, it is possible to realize high rate/high reliability data communication if the interleaved data buffer path is used and to shorten time required for the interleave processing if the fast data buffer path is used, so that a little transmission delay can be realized.

Third embodiment

In the second embodiment described above, by predetermining the number of bits allocated to each of the fast data buffer and the interleaved data buffer, a little transmission delay of the fast data buffer path is realized.

In this embodiment, the transmitting end allocates bits other than the lower two bits of the respective tones are allocated to the fast data buffer and allocates the remaining lower two bits to the interleaved data buffer from a bitmap obtained based on S/N, and the receiving end hard-determines the bits corresponding to the fast data buffer and turbo-decodes the bits corresponding to the interleaved data buffer, thereby realizing a little transmission delay of the fast data buffer path. It is noted that the same configurations as those in the preceding first and second embodiments are denoted by the same reference symbols and no description will be given thereto. In this embodiment, unlike the first and second embodiments, the transmitting end does not allocate tones using the multiplexer.

Now, the operations of the transmitting end and the receiving end in this embodiment will be described in detail with reference to Figs. 1 and 26. If data communication is held by the DMT modulation demodulation system using an existing transmission line such as a telephone line, for example, in the transmitting end, the tone ordering processing section 1 performs a tone ordering processing, i.e., a processing for allocating, to a plurality of tones in preset frequency bands, transmission data having bits which the respective tones can transmit, respectively based on the S/N ratio of the transmission line (which processing determines respective transmission rates).

Here, as shown in Fig. 25(a), for example, the bits other than the lower two bits of the respective tones are allocated to the fast data buffer and the remaining lower two bits thereof are allocated to the interleaved buffer from the bitmap of tone0 to tone9 as shown in.

Concretely, one bit of tone3, the higher one bit of tone4, the higher one bit of tone7, the higher two bits of tone5 and the higher two bits of tone6 are allocated as the data for the fast data buffer, and one bit of tone0, two bits of each of tone1, tone2, tone8 and tone9, and the lower two bits of each of tone3, tone4, tone5, tone6 and tone7 are allocated as the data for the interleaved data buffer. One frame is formed out of these 26 bits (information bits: 16 bits, redundant bits: 10 bits) . It is noted that many bits are allocated to the respective tones compared with the buffers shown (fast data buffer + interleaved data buffer) because redundant bits (2 bits) necessary for turbo encoding are added.

Further, one frame of the transmission data subjected to the tone ordering processing is constituted as shown in, for example, Fig. 26(b). To be specific, the tones are arranged in the order of one bit of tone3, one bit of tone4, one bit of tone7, two bits of tone5, two bits of tone6, one bit of tone0 and two bits of each of tone1 to tone9. One bit of tone0 and two bits of tone1, two bits of tone2 and two bits of tone3, two bits of tone4 and two bits of tone5, two bits of tone6 and two bits of tone7, and two bits of tone8 and two bits of tone9 are constituted as tone sets, respectively.

Thereafter, the data in the buffer constituted as shown in Fig. 26 are outputted as they are on the fast data buffer path and encoded for each tone set on the interleaved data buffer path. First, if data d0 to d6 of the tones (tone3, tone4, tone7, tones, tone6) allocated to the fast data buffer are inputted into the first mapper 4, eight information bits are outputted as they are.

Next, if data d0 of the tone set: tone2 and tone3 allocated to the interleaved data buffer and dummy data d_dummy (since information bits constitute one information bit sequence) are inputted into the terminals $u_1$ and $u_2$ of the turbo encoder 21 in the second mapper 5, then two information bits ($u_1$, $u_2$) and two redundant bits ($u_a$, $u_b$), i.e., turbo codes of four bits are outputted. The added two bits correspond to these redundant bits. Since the information bit $u_2$ is the dummy data, it is three bits of $u_1$, $u_a$ and $u_b$ that are actually encoded.

Next, if data d1 and d2 of the tone set: tone4 and tone 5 allocated to the interleaved data buffer are inputted into the terminals $u_1$ and $u_2$ of the turbo encoder 21 in the second mapper 5, two information bits ($u_1$, $u_2$) and two redundant bits ($u_a$, $u_b$), i.e., turbo codes of four bits are outputted. The added two bits correspond to these redundant bits.

Next, if data d3 and d4 of the tone set: tone4 and tone5 allocated to the interleaved data buffer are inputted into the terminals $u_1$ and $u_2$ of the turbo encoder 21 in the second mapper 5, two information bits ($u_1$, $u_2$) and two redundant bits ($u_a$, $u_b$), i.e., turbo codes of four bits are outputted. The added two bits correspond to these redundant bits.

Then, if data d5 and d6 of the tone set: tone6 and tone7 allocated to the interleaved data buffer are inputted into the terminals $u_1$ and $u_2$ of the turbo encoder 21 in the second mapper 5, two information bits ($u_1$, $u_2$) and two redundant bits ($u_a$, $u_b$), i.e., turbo codes of four bits are outputted. The added two bits correspond to these redundant bits.

Finally, if data d7 and d8 of the tone set: tone8 and tone9 allocated to the interleaved data buffer are inputted into the terminals $u_1$ and $u_2$ of the turbo encoder 21 in the second mapper 5, two information bits ($u_1$, $u_2$) and two redundant bits ($u_a$, $u_b$), i.e., turbo codes of four bits are outputted. The added two bits correspond to these redundant bits.

Meanwhile, on the receiving end, the demultiplexer 15 in the constellation decoder/gain scaling section 13 conducts a processing for allocating Fourier transformed frequency data to the tones on the fast data buffer path and the tones on the interleaved data buffer path based on the correspondence between the respective buffers and tones obtained by training. As for the tone the higher bits of which are allocated to the fast data buffer and the lower bits of which are allocated to the interleaved data buffer, the tone is allocated to both the paths.

Then, the first demapper 16 hard-determines bits on the allocated tones (tone3, tone4, tone5, tone6, tone7) on the fast data buffer path and outputs hard-determination data. Here, the hard-determination result is allocated to the bits: d0 to d6 corresponding to the fast data buffer, respectively.

In addition, the second demapper 17 turbo-decodes (see the turbo decoder shown in Fig. 4(b)) the allocated tone sets (tone0 and tone1, tone2 and tone3, tone4 and tone5, tone6 and tone7, and tone8 and tone9) on the interleaved data buffer path and outputs the turbo encoding result. Here, the turbo decoding result is allocated to the bits: d0 to d8 corresponding to the interleaved data buffer, respectively.

Finally, the first tone ordering section 18 and the second tone ordering section 19 receive the above-stated respective outputs and execute tone ordering processings separately on the fast data buffer path and the interleaved data buffer path, respectively. Since the following operation is the same as the operation of the receiving system shown in Fig. 3, no description will be given thereto.

As can be understood from the above, in this embodiment, the transmitting end allocates the bits other than the lower two bits of the respective tones to the fast data buffer and the remaining lower two bits thereof to the interleaved data buffer from the bitmap obtained based on S/N, and the receiving end hard-determines the bits corresponding to the fast data buffer and turbo-decodes the bits corresponding to the interleaved data buffer. By doing so, it is possible to realize high rate/high reliability data communication if the interleaved data buffer path is used and to reduce time required for the interleave processing if the fast data buffer is used, so that a little transmission delay can be realized.

Fourth embodiment

The preceding embodiments are on the premise of the two-input turbo encoder, i.e., the turbo encoder outputting turbo codes of four bits constituted out of two information bits and two redundant bits.

This embodiment corresponds to a one-input turbo encoder, i.e., a turbo encoder outputting turbo codes of two bits constituted out of one information bit and one redundant bit.

Fig. 27 is a block diagram showing an example of the configuration of a turbo encoder in this embodiment. In Fig. 27, reference symbol 71 denotes the first recursive organization convolutional encoder convolutional-encoding transmission data: $u_1$ corresponding to an information bit sequence and outputting redundant data: $u_a$, 72 denotes an interleaver, 73 denotes the second recursive organization convolutional encoder convolutional-encoding interleaved data: $u_{1t}$ after the interleave processing and outputting redundant data: $u_b$, and 74 denotes a puncturing circuit selecting one of the redundant data and outputting the selection result as redundant data: $u_0$. This turbo encoder simultaneously outputs the transmission data: $u_1$ and the redundant data: $d_0$.

Now, a method for searching an optimum recursive organization convolutional encoder in this embodiment will be described. Here, an encoder having a constraint length: 4 (the number of adders) and the number of memories: 3 is assumed as one example of the recursive organization convolutional encoder. First, to search an optimum recursive organization convolutional encoder, the connection patterns of all the recursive organization convolutional encoders which encoder may possibly have if an information bit: $u_1$ is inputted and recursive organization convolutional encoders satisfying optimum conditions below are detected.

Fig. 28 shows a method for expressing the recursive organization convolutional encoder in a case on the premise of a constraint length: 4 and the number of memories: 3. For example, if the information bit: $u_1$ is inputted into all adders and the redundant bit: $u_0$ is fed back to the respective adders other than that in the final stage, then the encoder can be expressed by a equation (23).

$$g = [h_0, h_1]$$

$$= [1111, 1111] \tag{23}$$

In addition, the optimum conditions for searching the recursive organization convolutional encoder can be expressed as follows:

(1) A pattern in which a block length is L, an input weight is 2, and the distance: de between two bits `1' of a self-terminating pattern (in a state in which the delay devices 61, 62 and 63 are all 0) becomes a maximum. To be specific, when the equation (7) described above becomes a minimum;
(2) A pattern in which an input length:2 and a total weight becomes a maximum in the above-stated pattern;
(3) A pattern in which a block length is L, an input weight is 3, and the distance: de between the bits `1' on the both ends of a self-terminating pattern becomes a maximum. To be specific, when the equation (7) described above becomes a minimum; and
(4) A pattern in which an input weight: 3 and a total weight becomes a maximum in the above-stated pattern.

Figs. 29 and 30 show optimum recursive organization convolutional encoders obtained by the search method in this embodiment. In a case on the premise of a constraint length: 4 and the number of memories: 3, the recursive organization convolutional encoder having a distance de = 7 and a total weight = 8 if an input weight is 2 and a distance de = 5 and a total weight = 7 if an input weight is 3, satisfies the above-stated optimum conditions . In addition, in a case on the premise of a constraint length: 5 and the number of memories: 4, the recursive organization convolutional encoder having a distance de = 15 and a total weight = 12 if an input weight is 2 and a distance de = 9 and a total weight = 8 if an input weight is 3, satisfies the above-stated optimum conditions.

To be specific, Fig. 29 shows the recursive organization convolutional encoder expressed as:

$$g = [h_0, h_1]$$

$$= [1101, 1111] \tag{24},$$

and Fig. 30 shows the recursive organization convolutional encoder expressed as:

$$g = [h_0, h_1]$$

$$= [11001, 11111] \tag{25}$$

In this way, if the recursive organization convolutional encoder having a constraint length: 4 and the number of memories: 3 or a constraint length: 5 and the number of memories: 4 is assumed, the optimum recursive organization convolutional encoder is determined so that the distance: de between the bits `1' of the self-terminating pattern at a block length: L and an input weight: 2 becomes a maximum and a total weight becomes a maximum in the pattern having the maximum distance de or so that the distance: de between the bits `1' of the self-terminating pattern at a block length: L and an input weight: 3 becomes a maximum and a total weight becomes a maximum in the pattern having the maximum distance de. By doing so, the communication device according to the present invention can correspond to the one-input turbo encoder, i.e., the turbo encoder outputting turbo codes of two bits constituted out of one information bit and one redundant bit. Besides, if this turbo encoder is employed, it is possible to greatly improve the BER characteristic of the receiving end of the communication device.

It is also possible that the turbo encoder in this embodiment is applied to the configurations of the transmitting ends in the first to third embodiments. In this case, a tone set which has been constituted out of two or four tones can be constituted out of one tone because the number of redundant bits is 1.

As stated so far, according to the present invention, it is constituted so that on the transmitting end and the receiving end, a processing on the first path and a processing on the second path are separated in units of tones, turbo encoding is not executed on the fast data buffer path, and turbo encoding is executed on the interleaved data buffer path. By thus constituting, it is possible to realize high rate/high reliability data communication if the interleaved data buffer path is used and further to reduce time required for the interleave processing if the fast data buffer path is used, so that a little transmission delay can be advantageously realized.

According to the next invention, it is constituted so that the number of bits allocated to each of the fast data buffer and the interleaved data buffer is predetermined and, if a tone set spreads over the two buffer, for example, the tone set is processed on the both paths, the bits corresponding to the fast data buffer are hard-determined and those corresponding to the interleaved data buffer are turbo-decoded. By thus constituting, it is possible to realize high rate/ high reliability data communication if the interleaved data buffer path is used and further to reduce time required for the interleave processing if the fast data buffer path is used, so that a little transmission delay can be advantageously realized.

According to the next invention, it is constituted so that the transmitting end allocates the bits other than the lower two bits, of the respective tones to the fast data buffer and the remaining lower two bits thereof to the interleaved data buffer from the bitmap obtained based on an S/N ratio, and that the receiving end hard-determines the bits corresponding to the fast data buffer and turbo-decodes those corresponding to the interleaved data buffer. By thus constituting, it is possible to realize high rate/high reliability data communication if the interleaved data buffer path is used and further to reduce time required for the interleave processing if the fast data buffer path is used, so that a little transmission delay can be advantageously realized.

According to the next invention, if the recursive organization convolutional encoder having a constraint length of 4 and the number of memories is 3 or the constraint length of 5 and the number of memories is 4 is assumed, the optimum recursive organization convolutional encoder is determined so that the distance: de between the bits `1' of the self-terminating pattern at a block length: L and an input weight: 2 becomes a maximum and a total weight becomes a maximum in the pattern having the maximum distance de. By doing so, the present invention can correspond to the one-input turbo encoder, i.e., the turbo encoder outputting turbo codes of two bits constituted out of one information bit and one redundant bit. Besides, if this turbo encoder is employed, it is possible to advantageously, greatly improve the BER characteristic of the receiving end of the communication device.

According to the next invention, it is constituted so that on the transmitting end, a processing on the first path and a processing on the second path are separated in units of tones, turbo encoding is not executed on the fast data buffer path, and turbo encoding is executed on the interleaved data buffer path. By thus constituting, it is possible to reduce time required for the interleave processing on the fast data buffer path, so that transmission delay can be advantageously, greatly reduced.

According to the next invention, it is constituted so that on the receiving end, a processing on the first path and a processing on the second path are separated in units of tones. By thus constituting, it is possible to reduce time required for the interleave processing on the fast data buffer path, so that transmission delay can be advantageously, greatly reduced.

According to the next invention, it is constituted so that the number of bits allocated to each of the fast data buffer and the interleaved data buffer is predetermined and, if a tone set spreads over the two buffer, for example, the tone set is processed on the both paths. By thus constituting, it is possible to reduce time required for the interleave processing on the fast data buffer path, so that transmission delay can be advantageously, greatly reduced.

According to the next invention, it is constituted so that on the transmission end, if a tone set spreads over the two buffer, the tone set is processed on the both paths, the bits corresponding to the fast data buffer are hard-determined and those corresponding to the interleaved data buffer are turbo-decoded. By thus constituting, it is possible to reduce time required for the interleave processing on the fast data buffer path, so that transmission delay can be advantageously, greatly reduced.

According to the next invention, it is constituted so that the bits other than the lower two bits, of the respective tones are allocated to the fast data buffer and the remaining lower two bits thereof are allocated to the interleaved data buffer from the bitmap obtained based on an S/N ratio. By thus constituting, it is possible to reduce time required for the interleave processing on the fast data buffer path, so that transmission delay can be advantageously, greatly reduced.

According to the next invention, it is constituted so that the bits corresponding to the fast data buffer are hard-determined and those corresponding to the interleaved data buffer are turbo-decoded. By thus constituting, it is possible to reduce time required for the interleave processing on the fast data buffer path, so that transmission delay can be advantageously, greatly reduced.

According to the next invention, at the transmission step and the receiving step, a processing on the first data buffer path and a processing on the interleaved data buffer path are separated in units of tones, turbo encoding is not executed on the fast data buffer path, and turbo encoding is executed on the interleaved data buffer path. By doing so, it is possible to realize high rate/high reliability data communication if the interleaved data buffer path is used and further to reduce time required for the interleave processing if the fast data buffer path is used, so that a little transmission delay can be advantageously realized.

According to the next invention, it is constituted so that the number of bits allocated to each of the fast data buffer and the interleaved data buffer is predetermined and, if a tone set spreads over the two buffer, for example, the tone set is processed on the both paths, the bits corresponding to the fast data buffer are hard-determined and those corresponding to the interleaved data buffer are turbo-decoded. By thus constituting, it is possible to realize high rate/ high reliability data communication if the interleaved data buffer path is used and further to reduce time required for the interleave processing if the fast data buffer path is used, so that a little transmission delay can be advantageously realized.

According to the next invention, at the transmission step, the bits other than the lower two bits, of the respective tones are allocated to the fast data buffer and the remaining lower two bits thereof are allocated to the interleaved data buffer from the bitmap obtained based on an S/N ratio, and at the receiving step, the bits corresponding to the fast data buffer are hard-determined and those corresponding to the interleaved data buffer are turbo-decoded. By doing so, it is possible to realize high rate/high reliability data communication if the interleaved data buffer path is used and further to reduce time required for the interleave processing if the fast data buffer path is used, so that a little transmission delay can be advantageously realized.

INDUSTRIAL APPLICABILITY

As stated so far, the communication device and the communication method according to the present invention are suited for data communication using an existing communication line by the DMT (Discrete Multi Tone) modulation demodulation system, the OFDM (Orthogonal Frequency Division Multiplex) modulation demodulation system or the like.

**Claims**

1. A communication device comprising: a first path having a little delay; and a second path to which more delay than the delay of said first path occurs, comprising:

    a transmission section separating a processing on said first path and a processing on said second path in units of tones, allowing a buffer on said first path to secure a transmission rate to an extent that communication can be held and then outputting data on the communication without being encoded, and allowing a buffer on said second path to secure remaining tones and then turbo-encoding and outputting bits on the tones; and
    a receiving section allocating Fourier-transformed frequency data to said first path and said second path in units of tones, respectively, and hard-determining bits on the tones allocated to said first path and turbo-decoding bits on the tones allocated to said second path.

2. A communication device comprising: a first path having a little delay; and a second path to which more delay than the delay of said first path occurs, comprising:

a transmission section predetermining the number of bits allocated to a buffer on said first path and a buffer on said second path, respectively, outputting the bits on tones allocated to the buffer on said first path without being encoded by a tone ordering processing, outputting the bits on tones allocated to the buffer on said second path with being turbo-encoded, and if the allocated tones spread over the two buffers, individually processing the tones on the both paths; and

a receiving section allocating Fourier-transformed frequency data to said first path and said second path in units of tones, respectively, hard-determining the bits on the tones allocated to said first path and turbo-decoding the bits on the tones allocated to said second path, and individually processing the tones spreading over said two buffers on the both paths.

3. A communication device comprising: a first path having a little delay; and a second path to which more delay than the delay of said first path occurs, comprising:

a transmission section allocating bits, other than lower two bits, of respective tones to a buffer on said first path from a bitmap obtained based on an S/N ratio and then outputting the bits allocated to the buffer without being encoded, and allocating the remaining lower two bits to a buffer on said second path and then turbo-encoding and outputting the bits allocated to the buffer; and

a receiving section allocating the tones including the bits which are not encoded in Fourier-transformed frequency data to said first path and the tones including the turbo-encoded bits to said second path, respectively, and then hard-determining the bits on the tones allocated to said first path and turbo-decoding the bits on the tones allocated to said second path.

4. A communication device comprising: a first recursive organization convolutional encoder convolutional-encoding an information bit sequence of one system and outputting first redundant data; a second recursive organization convolutional encoder convolutional-encoding the information bit sequence after being interleaved and outputting second redundant data; and a puncturing circuit thinning out each redundant data at predetermined timing and outputting one of the redundant bits, wherein

if the recursive organization convolutional encoder having a constraint length of "5" and the number of memories is "4" or the constraint length of "4" and the number of memories is "3" is assumed, all connection patterns constituting the encoder are searched; and

the encoder satisfying optimal conditions that a distance between two bits "1" of a self-terminating pattern with a specific block length becomes a maximum and that a total weight becomes a maximum in the pattern having the maximum distance, is provided as each of said first and second recursive organization convolutional encoders.

5. A communication device comprising: a first path having a little delay; and a second path to which more delay than the delay of said first path occurs, comprising:

a transmission section separating a processing on said first path and a processing on said second path in units of tones, allowing a buffer on said first path to secure a transmission rate to an extent that communication can be held and then outputting data on the communication without being encoded, and allowing a buffer on said second path to secure remaining tones and then turbo-encoding and outputting bits on the tones.

6. A communication device comprising: a first path having a little delay; and a second path to which more delay than the delay of said first path occurs, comprising:

a receiving section allocating Fourier-transformed frequency data to said first path and said second path in units of tones, respectively, and hard-determining bits on the tones allocated to said first path and turbo-decoding bits on the tones allocated to said second path.

7. A communication device comprising: a first path having a little delay; and a second path to which more delay than the delay of said first path occurs, comprising:

a transmission section predetermining the number of bits allocated to a buffer on said first path and a buffer on said second path, respectively, outputting the bits on tones allocated to the buffer on said first path without being encoded by a tone ordering processing, outputting the bits on tones allocated to the buffer on said second path with being turbo-encoded, and if the allocated tones spread over the two buffers, individually processing the tones on the both paths.

8. A communication device comprising: a first path having a little delay; and a second path to which more delay than the delay of said first path occurs, comprising:

a receiving section allocating Fourier-transformed frequency data to said first path and said second path in units of tones, respectively, hard-determining bits on tones allocated to said first path and turbo-decoding bits on tones allocated to said second path, and individually processing the tones spreading over said two buffers on the both paths.

9. A communication device comprising: a first path having a little delay; and a second path to which more delay than the delay of said first path occurs, comprising:

a transmission section allocating bits, other than lower two bits, of respective tones to a buffer on said first path from a bitmap obtained based on an S/N ratio and then outputting the bits allocated to the buffer without being encoded, and allocating the remaining lower two bits to a buffer on said second path and then turbo-encoding and outputting the bits allocated to the buffer.

10. A communication device comprising : a first path having a little delay; and a second path to which more delay than the delay of said first path occurs, comprising:

a receiving section allocating tones including bits, which are not encoded, in Fourier-transformed frequency data to said first path and tones including turbo-encoded bits to said second path, respectively, and then hard-determining the bits on the tones allocated to said first path and turbo-decoding the bits on the tones allocated to said second path.

11. A communication method using: a first path having a little delay; and a second path to which more delay than the delay of said first path occurs, comprising:

a transmission step of separating a processing on said first path and a processing on said second path in units of tones, allowing a buffer on said first path to secure a transmission rate to an extent that communication can be held and then outputting data on the communication without being encoded, and allowing a buffer on said second path to secure remaining tones and then turbo-encoding and outputting bits on the tones; and a receiving step of allocating Fourier-transformed frequency data to said first path and said second path in units of tones, respectively, and hard-determining bits on the tones allocated to said first path and turbo-decoding bits on the tones allocated to said second path.

12. A communication method using: a first path having a little delay; and a second path to which more delay than the delay of said first path occurs, comprising:

a transmission step of predetermining the number of bits allocated to a buffer on said first path and a buffer on said second path, respectively, outputting the bits on tones allocated to the buffer on said first path without being encoded by a tone ordering processing, outputting the bits on tones allocated to the buffer on said second path with being turbo-encoded, and if the allocated tones spread over the two buffers, individually processing the tones on the both paths; and a receiving step of allocating Fourier-transformed frequency data to said first path and said second path in units of tones, respectively, hard-determining the bits on the tones allocated to said first path and turbo-decoding the bits on the tones allocated to said second path, and individually processing the tones spreading over said two buffers on the both paths.

13. A communication method using: a first path having a little delay; and a second path to which more delay than the delay of said first path occurs, comprising:

a transmission step of allocating bits, other than lower two bits, of respective tones to a buffer on said first path from a bitmap obtained based on an S/N ratio and then outputting the bits allocated to the buffer without being encoded, and allocating the remaining lower two bits to a buffer on said second path and then turbo-encoding and outputting the bits allocated to the buffer; and a receiving step of allocating the tones including the bits which are not encoded in Fourier-transformed frequency data to said first path and the tones including the turbo-encoded bits to said second path, respectively, and then hard-determining the bits on the tones allocated to said first path and turbo-decoding the bits on the tones allocated to said second path.

# FIG.1

## (a)

FAST DATA BUFFER PATH →
INTERLEAVED DATA BUFFER PATH →

TONE ORDERING SECTION *1*

CONSTELLATION ENCODER/ GAIN SCALING SECTION *2*

FIRST MAPPER *4*

SECOND MAPPER *5*

MULTI-PLEXER *6*

INVERSE FAST FOURIER TRANSFORM SECTION *3*

→ TRANSMISSION LINE

## (b)

FAST DATA BUFFER PATH →
INTERLEAVED DATA BUFFER PATH →

TONE ORDERING SECTION *14*

FIRST TONE ORDERING SECTION *18*

SECOND TONE ORDERING SECTION *19*

CONSTELLATION DECODER/ GAIN SCALING SECTION *13*

FIRST DEMAPPER (HARD-DETERMINATION) *16*

SECOND DEMAPPER (TURBO ENCODING) *17*

DEMULTI-PLEXER *15*

FREQUENCY DOMAIN EQUALIZER *12*

FAST FOURIER TRANSFORM SECTION *11*

→ TRANSMISSION LINE

# FIG.2

# FIG.3

```
                                              ┌─141
                                              │  ANALOG        ◄── RECEIVED
                                              │  PROCESSING        SIGNAL
                                              │  AND ADC
                                              └────────

                                                          ┌─142
                                                       ┌──────┐
                                                       │ TEQ  │
                                                       └──────┘

  ┌─147        ┌─146        ┌─145     ┌─144       ┌─143
┌────────┐  ┌────────────┐ ┌──────┐ ┌──────┐  ┌─────────┐
│        │  │ CONSTE-    │ │      │ │      │  │ INPUT   │
│  TONE  │  │ LLATION    │ │ FEQ  │ │ FFT  │  │ SERIAL/ │
│ORDERING│  │ DECODER    │ │      │ │      │  │ PARALLEL│
│        │  │ AND        │ │      │ │      │  │ BUFFER  │
│        │  │ GAIN       │ │      │ │      │  │         │
│        │  │ SCALLING   │ │      │ │      │  │         │
└────────┘  └────────────┘ └──────┘ └──────┘  └─────────┘

                                      ┌─148              ┌─149
                                   ┌──────────┐      ┌──────────┐
                                   │  RATE-   │      │  RATE-   │
                                   │CONVERTOR │      │CONVERTOR │
                                   └──────────┘      └──────────┘

  ┌─155    ┌─153      ┌─151
┌────────┐ ┌────┐ ┌──────────────┐
│MUX/SYNC│ │CRC │ │ DESCRAM&FEC  │
│CONTROL │ │    │ │              │
│        │ └────┘ └──────────────┘
◄──       
│        │ ┌─154      ┌─152            ┌─150
│        │ ┌────┐ ┌──────────────┐ ┌──────────────┐
└────────┘ │CRC │ │ DESCRAM&FEC  │ │ DEINTERLEAVE │
           └────┘ └──────────────┘ └──────────────┘
```

# FIG.4

(a)

⋮

$U_4$ ⟶ $U_4$

$U_3$ ⟶ $U_3$

$U_2$ ⟶ TURBO ENCODER ⟶ $U_2$

$U_1$ ⟶ ⟶ $U_1$

⟶ $U_a$

⟶ $U_b$

21

(b)

Lcy
=
$(y_3, y_4, \cdots)$

THIRD DETERMINATION UNIT — 33

$L_a(u_k) = 0$ ⟶ switch B

A
intial:A
after second:B

Lcy
=
$(y_1, y_2, y_a, y_b)$

FIRST DECODER — 22

$L(u'_k)$ ⊕ 23 $- Le(u_k)$ +

INTER-LEAVER — 24 $L_a(u_k)$

INTER-LEAVER — 25

SECOND DECODER — 26

$L(u'_k)$ ⊕ 27 $- Le(u_k)$ +

DEINTER-LEAVER — 28

FIRST DETER-MINATION UNIT — 29

FIRST R/S DECODER — 30

SECOND DETERMINA-TION UNIT — 31

SECOND R/S DECODER — 32

29

# FIG.5

(a)

(b)

(c)

# FIG.6

(a)

(b)

# FIG.7

# FIG.8

EP 1 209 837 A1

# FIG.9

EP 1 209 837 A1

# FIG.10

# FIG.11

====generation polynominal=[10011,11101,10001]

| u2 | u1 | u0 | state |
|----|----|----|-------|
| 0 | 1 | 1 | 0111 |
| 0 | 0 | 1 | 1010 |
| 0 | 0 | 0 | 0101 |
| 0 | 0 | 1 | 1011 |
| 0 | 0 | 1 | 1100 |
| 0 | 0 | 0 | 0110 |
| 0 | 0 | 0 | 0011 |
| 0 | 0 | 1 | 1000 |
| 0 | 0 | 0 | 0100 |
| 0 | 0 | 0 | 0010 |
| 1 | 0 | 1 | 0000 |
| 0 | 0 | 0 | 0000 |
| 0 | 0 | 0 | 0000 |
| 0 | 0 | 0 | 0000 |
| 0 | 0 | 0 | 0000 |
| 0 | 0 | 0 | 0000 |

information weight=2 weight total=8

# FIG.12

====generation polynominal=[11001,10001,10111]

| u2 | u1 | u0 | state |
|----|----|----|-------|
| 0 | 1 | 1 | 0100 |
| 0 | 0 | 0 | 0010 |
| 0 | 0 | 0 | 0001 |
| 0 | 0 | 1 | 1100 |
| 0 | 0 | 0 | 0110 |
| 0 | 0 | 0 | 0011 |
| 0 | 0 | 1 | 1101 |
| 0 | 0 | 1 | 1010 |
| 0 | 0 | 0 | 0101 |
| 0 | 0 | 1 | 1110 |
| 1 | 0 | 1 | 0000 |
| 0 | 0 | 0 | 0000 |
| 0 | 0 | 0 | 0000 |
| 0 | 0 | 0 | 0000 |
| 0 | 0 | 0 | 0000 |
| 0 | 0 | 0 | 0000 |

information weight=2 weight total=8

FIG.13

## FIG.14

## FIG.15

# FIG.16

# FIG.17

# FIG.18

# FIG.19

====generation polynominal=[1011,1101,0101]

| u2 | u1 | u0 | state |
|----|----|----|-------|
| 0 | 1 | 1 | 011 |
| 0 | 0 | 1 | 100 |
| 0 | 0 | 0 | 010 |
| 0 | 0 | 0 | 001 |
| 0 | 0 | 1 | 101 |
| 1 | 0 | 0 | 000 |
| 0 | 0 | 0 | · |
| 0 | 0 | 0 | · |
| · | · | · | · |
| · | · | · | · |
| · | · | · | · |

information weight=2    weight total=5

# FIG.20

====generation polynominal=[1011,1110,1001]

| u2 | u1 | u0 | state |
|----|----|----|-------|
| 0 | 1 | 0 | 111 |
| 0 | 0 | 1 | 110 |
| 0 | 0 | 0 | 011 |
| 0 | 0 | 1 | 100 |
| 0 | 0 | 0 | 010 |
| 1 | 0 | 1 | 000 |
| 0 | 0 | 0 | . |
| 0 | 0 | 0 | . |
| . | . | . | . |
| . | . | . | . |
| . | . | . | . |

information weight=2    weight total=5

# FIG.21

====generation polynominal=[1101,1001,0111]

| u2 | u1 | u0 | state |
|----|----|----|-------|
| 0 | 1 | 1 | 010 |
| 0 | 0 | 0 | 001 |
| 0 | 0 | 1 | 110 |
| 0 | 0 | 0 | 011 |
| 0 | 0 | 1 | 111 |
| 1 | 0 | 0 | 000 |
| 0 | 0 | 0 | . |
| 0 | 0 | 0 | . |
| . | . | . | . |
| . | . | . | . |
| . | . | . | . |

information weight=2    weight total=5

# FIG.22

====generation polynominal=[1101,1010,1011]

| u2 | u1 | u0 | state |
|----|----|----|-------|
| 0  | 1  | 0  | 101   |
| 0  | 0  | 1  | 100   |
| 0  | 0  | 0  | 010   |
| 0  | 0  | 0  | 001   |
| 0  | 0  | 1  | 110   |
| 1  | 0  | 1  | 000   |
| 0  | 0  | 0  | .     |
| 0  | 0  | 0  | .     |
| .  | .  | .  | .     |
| .  | .  | .  | .     |
| .  | .  | .  | .     |
| .  | .  | .  | .     |

information weight=2    weight total=5

# FIG.23

(a)

SNR

TONE ORDERED
$b_0'=b_9=0$
$b_1'=b_0=1$
$b_2'=b_1=1$
$b_3'=b_7=1$
$b_4'=b_8=1$
$b_5'=b_6=2$
$b_6'=b_2=3$
$b_7'=b_5=4$
$b_8'=b_3=5$
$b_9'=b_4=6$

TONE INDEX

(b)

DATA FRAME BUFFER

FAST DATA BUFFER · INTERLEAVED DATA BUFFER

lsb · msb · lsb · msb

$d_0$ $d_1$ $d_2$ $d_3$ $d_4$ $d_5$ $d_6$ $d_7$ $d_0$ $d_1$ $d_2$ $d_3$ $d_4$ $d_5$ $d_6$ $d_7$

$b_0'+b_1'+b_2'+b_3'-2$ $b_4'+b_5'-'2$ $b_6'+b_7'-2$ $b_8'+b_9'-2$

TONE9 0bit · TONE0 1bit · TONE1 1bit · TONE7 1bit · TONE8 1bit · TONE6 2bit · TONE2 3bit · TONE5 4bit · TONE3 5bit · TONE4 6bit

(a)

# FIG.24

SNR

tone orderd
$b_0'=b_0=0$
$b_1'=b_1=1$
$b_2'=b_2=1$
$b_3'=b_8=1$
$b_4'=b_9=1$
$b_5'=b_3=2$
$b_6'=b_4=2$
$b_7'=b_7=2$
$b_8'=b_5=4$
$b_9'=b_6=4$

| 0bit | 1bit | 1bit | 2bit | 2bit | 4bit | 4bit | 2bit | 1bit | 1bit |

tone index
0  1  2  3  4  5  6  7  8  9

(b)

lsb    Fast data buffer    msb    lsb    Interleaved data buffer    msb

| $d_0$ | $d_1$ | $d_2$ | $d_3$ | $d_4$ | $d_5$ | $d_6$ | $d_7$ | $d_8$ | $d_9$ | $d_0$ | $d_1$ | $d_2$ | $d_3$ | $d_4$ | $d_5$ |

$b_0'+b_1'$    $b_2'+b_3'$    $b_4'+b_5'$    $b_6'+b_7'$    $b_8'+b_9'-2$

tone0   tone1   tone2   tone8   tone9   tone3   tone4   tone7   tone5   tone6
0bit    1bit    1bit    1bit    1bit    2bit    2bit    2bit    4bit    4bit

# FIG.25

(a)

SNR

0bit 1bit 1bit 2bit (3bit) 2bit 4bit 4bit (3bit) 2bit 1bit 1bit

0 1 2 3 4 5 6 7 8 9

tone index

tone orderd
$b_0'=b_0=1$
$b_1'=b_1=2$
$b_2'=b_2=2$
$b_3'=b_8=2$
$b_4'=b_9=2$
$b_5'=b_3=3$
$b_6'=b_4=3$
$b_7'=b_7=3$
$b_8'=b_5=4$
$b_9'=b_6=4$

(b)

Fast data buffer

lsb                                        msb

Interleaved data buffer

lsb                                        msb

$d_0$ | $d_1$ | $d_2$ | $d_3$ | $d_4$ | $d_5$ | $d_6$ | $d_7$ | $d_8$ | $d_9$ | $d_0$ | $d_1$ | $d_2$ | $d_3$ | $d_4$ | $d_5$

$b_0'+b_1'$  $b_2'+b_3'$  $b_4'+b_5'$  $b_6'+b_7'(-2)$  $b_8'+b_9'-2$

tone1 tone1 tone2 tone8 tone9 tone3 tone4 tone7 tone5 tone6

0bit  1bit  1bit  1bit  1bit  2bit  2bit  2bit  4bit  4bit
                                            (3bit) (3bit)

# FIG.26

(a)

(b)

# FIG.27

# FIG.28

# FIG.29

# FIG.30

# FIG.31

(a)

DATA O————•————•————————————————►X₁

FIRST RECURSIVE ORGANIZATION CONVOLUTIONAL ENCODER  101
————►X₂

INTERLEAVER  102

SECOND RECURSIVE ORGANIZATION CONVOLUTIONAL ENCODER  103
————►X₃

(b)

# FIG.32

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 54 | 74 | 70 | 92 | 77 | 80 | 90 | 88 | 99 | 65 | 93 | 98 | 97 | 76 | 59 | 73 | 102 | 75 | 91 | 56 |
| 3 | 107 | 151 | 117 | 124 | 121 | 145 | 112 | 111 | 119 | 108 | 143 | 128 | 142 | 136 | 131 | 118 | 116 | 132 | 110 | 127 |
| 4 | 160 | 192 | 188 | 162 | 205 | 193 | 168 | 191 | 208 | 186 | 202 | 200 | 187 | 182 | 176 | 190 | 175 | 210 | 199 | 207 |
| 5 | 213 | 224 | 250 | 244 | 225 | 262 | 229 | 257 | 222 | 226 | 221 | 214 | 236 | 235 | 223 | 238 | 259 | 246 | 249 | 232 |
| 6 | 266 | 268 | 274 | 292 | 293 | 296 | 305 | 279 | 307 | 285 | 272 | 286 | 275 | 295 | 302 | 270 | 280 | 310 | 294 | 299 |
| 7 | 319 | 348 | 370 | 341 | 319 | 348 | 370 | 341 | 319 | 348 | 370 | 341 | 319 | 348 | 370 | 341 | 319 | 388 | 370 | 341 |
| 8 | 372 | 405 | 414 | 402 | 418 | 379 | 378 | 397 | 407 | 376 | 382 | 374 | 420 | 394 | 411 | 406 | 395 | 392 | 396 | 373 |
| 9 | 425 | 446 | 431 | 472 | 473 | 442 | 449 | 444 | 440 | 458 | 430 | 450 | 466 | 447 | 453 | 426 | 468 | 430 | 467 | 469 |
| 10 | 478 | 479 | 481 | 485 | 493 | 509 | 488 | 499 | 521 | 512 | 494 | 511 | 492 | 507 | 484 | 491 | 505 | 480 | 483 | 489 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 63 | 104 | 64 | 72 | 81 | 58 | 105 | 85 | 89 | 67 | 82 | 79 | 69 | 71 | 60 | 94 | 66 | 61 | 62 | 83 |
| 3 | 150 | 125 | 113 | 156 | 130 | 126 | 158 | 114 | 148 | 141 | 144 | 120 | 153 | 154 | 146 | 157 | 122 | 137 | 123 | 129 |
| 4 | 206 | 173 | 197 | 194 | 201 | 167 | 211 | 179 | 183 | 209 | 166 | 178 | 203 | 180 | 163 | 185 | 169 | 171 | 184 | 189 |
| 5 | 240 | 230 | 216 | 260 | 258 | 234 | 264 | 253 | 227 | 233 | 252 | 215 | 246 | 220 | 255 | 251 | 256 | 263 | 241 | 242 |
| 6 | 314 | 306 | 282 | 316 | 312 | 300 | 319 | 315 | 309 | 291 | 290 | 287 | 218 | 304 | 276 | 298 | 311 | 297 | 308 | 288 |
| 7 | 319 | 348 | 370 | 341 | 319 | 348 | 370 | 341 | 319 | 348 | 370 | 341 | 319 | 348 | 370 | 341 | 319 | 348 | 370 | 341 |
| 8 | 386 | 404 | 380 | 412 | 387 | 385 | 423 | 390 | 381 | 393 | 377 | 416 | 417 | 398 | 388 | 419 | 413 | 421 | 375 | 401 |
| 9 | 460 | 474 | 464 | 456 | 439 | 436 | 476 | 455 | 470 | 429 | 428 | 459 | 452 | 457 | 461 | 443 | 471 | 451 | 435 | 454 |
| 10 | 501 | 525 | 520 | 510 | 490 | 503 | 529 | 528 | 526 | 522 | 514 | 498 | 519 | 508 | 486 | 495 | 543 | 496 | 515 | 500 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 100 | 86 | 57 | 84 | 68 | 103 | 96 | 55 | 95 | 87 | 78 | 101 | 53 |
| 3 | 134 | 147 | 149 | 133 | 155 | 138 | 115 | 140 | 152 | 109 | 135 | 139 | 106 |
| 4 | 195 | 181 | 196 | 161 | 172 | 164 | 165 | 198 | 174 | 177 | 170 | 204 | 159 |
| 5 | 254 | 239 | 218 | 231 | 228 | 245 | 237 | 247 | 261 | 217 | 219 | 243 | 212 |
| 6 | 281 | 313 | 303 | 273 | 289 | 284 | 269 | 277 | 301 | 267 | 271 | 283 | 265 |
| 7 | 319 | 348 | 370 | 341 | 319 | 348 | 370 | 341 | 319 | 348 | 370 | 341 | 318 |
| 8 | 384 | 389 | 400 | 403 | 399 | 422 | 409 | 391 | 415 | 383 | 408 | 410 | 371 |
| 9 | 448 | 475 | 433 | 463 | 434 | 432 | 441 | 427 | 437 | 445 | 462 | 465 | 424 |
| 10 | 523 | 516 | 502 | 527 | 524 | 518 | 506 | 482 | 487 | 497 | 517 | 504 | 477 |

FIG.33

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 1 | 19 | 43 | 22 | 47 | 45 | 7 | 27 | 36 | 48 | 11 | 50 | 49 | 30 | 40 | 18 | 24 | 32 | 25 | 51 |
| 2 | 1 | 21 | 17 | 39 | 24 | 27 | 37 | 35 | 46 | 12 | 40 | 45 | 44 | 23 | 6 | 20 | 49 | 22 | 38 | 3 |
| 3 | 1 | 45 | 11 | 18 | 15 | 39 | 6 | 5 | 13 | 2 | 37 | 22 | 36 | 30 | 25 | 12 | 10 | 26 | 4 | 21 |
| 4 | 1 | 33 | 29 | 3 | 46 | 34 | 9 | 32 | 49 | 27 | 43 | 41 | 28 | 23 | 17 | 31 | 16 | 51 | 40 | 48 |
| 5 | 1 | 12 | 38 | 32 | 13 | 50 | 17 | 45 | 10 | 14 | 9 | 2 | 24 | 23 | 11 | 26 | 47 | 34 | 37 | 20 |
| 6 | 1 | 3 | 9 | 27 | 28 | 31 | 40 | 14 | 42 | 20 | 7 | 21 | 10 | 30 | 37 | 5 | 15 | 45 | 29 | 34 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 1 | 34 | 43 | 31 | 47 | 8 | 7 | 26 | 36 | 5 | 11 | 3 | 49 | 23 | 40 | 35 | 24 | 21 | 25 | 2 |
| 9 | 1 | 22 | 7 | 48 | 49 | 18 | 25 | 20 | 16 | 34 | 6 | 26 | 42 | 23 | 29 | 2 | 44 | 14 | 43 | 45 |
| 10 | 1 | 2 | 4 | 8 | 16 | 32 | 11 | 22 | 44 | 35 | 17 | 34 | 15 | 30 | 7 | 14 | 28 | 3 | 6 | 12 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 15 | 20 | 9 | 12 | 16 | 39 | 52 | 34 | 10 | 31 | 6 | 8 | 46 | 26 | 17 | 5 | 42 | 3 | 4 | 23 |
| 2 | 10 | 51 | 11 | 19 | 28 | 5 | 52 | 32 | 36 | 14 | 29 | 26 | 16 | 18 | 7 | 41 | 13 | 8 | 9 | 30 |
| 3 | 44 | 19 | 7 | 50 | 24 | 20 | 32 | 8 | 42 | 35 | 38 | 14 | 47 | 48 | 40 | 51 | 16 | 31 | 17 | 23 |
| 4 | 47 | 14 | 38 | 35 | 42 | 8 | 52 | 20 | 24 | 50 | 7 | 19 | 44 | 21 | 4 | 26 | 10 | 12 | 25 | 30 |
| 5 | 28 | 18 | 4 | 48 | 46 | 22 | 52 | 41 | 15 | 21 | 40 | 3 | 36 | 8 | 43 | 39 | 44 | 51 | 29 | 30 |
| 6 | 49 | 41 | 17 | 51 | 47 | 35 | 52 | 50 | 44 | 26 | 25 | 22 | 13 | 39 | 11 | 33 | 46 | 32 | 43 | 23 |
| 7 | 1 | 30 | 52 | 23 | 1 | 30 | 52 | 23 | 1 | 30 | 52 | 23 | 1 | 30 | 52 | 23 | 1 | 30 | 52 | 23 |
| 8 | 15 | 33 | 9 | 41 | 16 | 14 | 52 | 19 | 10 | 22 | 6 | 45 | 46 | 27 | 17 | 48 | 42 | 50 | 4 | 30 |
| 9 | 36 | 50 | 40 | 32 | 15 | 12 | 52 | 31 | 46 | 5 | 4 | 35 | 28 | 33 | 37 | 19 | 47 | 27 | 11 | 30 |
| 10 | 24 | 48 | 43 | 33 | 13 | 26 | 52 | 51 | 49 | 45 | 37 | 21 | 42 | 31 | 9 | 18 | 36 | 19 | 38 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 13 | 35 | 29 | 21 | 28 | 2 | 38 | 33 | 44 | 41 | 37 | 14 | 0 |
| 2 | 47 | 33 | 4 | 31 | 15 | 50 | 43 | 2 | 42 | 34 | 25 | 48 | 0 |
| 3 | 28 | 41 | 43 | 27 | 49 | 32 | 9 | 34 | 46 | 3 | 29 | 33 | 0 |
| 4 | 36 | 22 | 37 | 2 | 13 | 5 | 6 | 39 | 15 | 18 | 11 | 45 | 0 |
| 5 | 42 | 27 | 6 | 19 | 16 | 33 | 25 | 35 | 49 | 5 | 7 | 31 | 0 |
| 6 | 16 | 48 | 38 | 8 | 24 | 19 | 4 | 12 | 36 | 2 | 6 | 18 | 0 |
| 7 | 1 | 30 | 52 | 23 | 1 | 30 | 52 | 23 | 1 | 30 | 52 | 23 | 0 |
| 8 | 13 | 18 | 29 | 32 | 28 | 51 | 38 | 20 | 44 | 12 | 37 | 39 | 0 |
| 9 | 24 | 51 | 9 | 39 | 10 | 8 | 17 | 3 | 13 | 21 | 38 | 41 | 0 |
| 10 | 45 | 39 | 25 | 50 | 47 | 41 | 29 | 5 | 10 | 20 | 40 | 27 | 0 |

FIG.34

| N\M | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|---|---|---|---|---|---|---|---|---|---|---|
| 1 | 478 | 479 | 481 | 485 | 493 | 209 | 488 | 499 | 521 | 512 | 494 | 511 | 492 | 507 | 484 | 491 | 505 | 480 | 483 | 489 |
| 2 | 425 | 446 | 431 | 472 | 473 | 442 | 449 | 444 | 440 | 458 | 430 | 450 | 466 | 447 | 463 | 426 | 468 | 438 | 467 | 469 |
| 3 | 372 | 405 | 414 | 402 | 418 | 379 | 378 | 397 | 407 | 276 | 382 | 374 | 429 | 394 | 411 | 406 | 395 | 392 | 396 | 373 |
| 4 | 319 | 348 | 970 | 341 | 319 | 348 | 970 | 341 | 319 | 348 | 370 | 341 | 319 | 348 | 370 | 341 | 319 | 348 | 370 | 341 |
| 5 | 266 | 268 | 274 | 292 | 293 | 296 | 305 | 279 | 307 | 285 | 272 | 286 | 275 | 295 | 302 | 270 | 280 | 210 | 294 | 299 |
| 6 | 213 | 224 | 250 | 244 | 225 | 262 | 229 | 257 | 222 | 226 | 221 | 214 | 236 | 235 | 223 | 238 | 259 | 246 | 249 | 232 |
| 7 | 160 | 192 | 108 | 162 | 205 | 193 | 168 | 191 | 208 | 186 | 202 | 200 | 187 | 182 | 176 | 190 | 175 | 210 | 199 | 207 |
| 8 | 107 | 151 | 117 | 124 | 121 | 145 | 112 | 111 | 119 | 108 | 143 | 128 | 142 | 136 | 131 | 118 | 116 | 132 | 110 | 127 |
| 9 | 54 | 74 | 70 | 90 | 77 | 80 | 90 | 88 | 99 | 65 | 93 | 98 | 97 | 76 | 59 | 73 | 102 | 75 | 91 | 56 |
| 10 | 1 | 19 | 43 | 22 | 47 | 45 | 7 | 27 | 36 | 48 | 11 | 50 | 49 | 30 | 40 | 18 | 24 | 32 | 25 | 51 |

| N\M | 21 | 22 | 23 | 24 | 25 | 26 | 27 | 28 | 29 | 30 | 31 | 32 | 33 | 34 | 35 | 36 | 37 | 38 | 39 | 40 |
|---|---|---|---|---|---|---|---|---|---|---|---|---|---|---|---|---|---|---|---|---|
| 1 | 501 | 525 | 520 | 510 | 490 | 503 | 529 | 528 | 526 | 522 | 514 | 498 | 519 | 508 | 486 | 495 | 513 | 496 | 515 | 500 |
| 2 | 460 | 474 | 464 | 456 | 439 | 436 | 476 | 455 | 470 | 429 | 428 | 459 | 452 | 457 | 461 | 443 | 471 | 451 | 135 | 454 |
| 3 | 386 | 404 | 380 | 412 | 387 | 382 | 423 | 390 | 381 | 393 | 377 | 416 | 417 | 398 | 388 | 419 | 413 | 421 | 375 | 401 |
| 4 | 319 | 348 | 370 | 341 | 319 | 348 | 370 | 341 | 319 | 348 | 370 | 341 | 319 | 348 | 470 | 341 | 319 | 348 | 370 | 341 |
| 5 | 314 | 306 | 282 | 316 | 312 | 300 | 317 | 315 | 309 | 291 | 290 | 287 | 278 | 304 | 276 | 298 | 311 | 297 | 308 | 288 |
| 6 | 240 | 230 | 216 | 260 | 258 | 234 | 264 | 253 | 227 | 233 | 252 | 215 | 248 | 220 | 255 | 251 | 256 | 263 | 241 | 242 |
| 7 | 206 | 173 | 197 | 194 | 201 | 167 | 211 | 179 | 183 | 209 | 166 | 178 | 203 | 180 | 163 | 485 | 169 | 171 | 184 | 189 |
| 8 | 150 | 125 | 113 | 156 | 130 | 126 | 150 | 114 | 148 | 141 | 144 | 120 | 153 | 154 | 146 | 157 | 122 | 137 | 123 | 129 |
| 9 | 63 | 104 | 64 | 72 | 81 | 58 | 105 | 85 | 89 | 67 | 82 | 79 | 69 | 71 | 60 | 94 | 66 | 61 | 62 | 83 |
| 10 | 15 | 20 | 9 | 12 | 16 | 39 | 52 | 34 | 10 | 31 | 6 | 8 | 46 | 26 | 17 | 5 | 42 | 3 | 4 | 23 |

| N\M | 41 | 42 | 43 | 44 | 45 | 46 | 47 | 48 | 49 | 50 | 51 | 52 | 53 |
|---|---|---|---|---|---|---|---|---|---|---|---|---|---|
| 1 | 523 | 516 | 502 | 527 | 524 | 518 | 506 | 482 | 487 | 497 | 517 | 504 | 477 |
| 2 | 448 | 475 | 433 | 463 | 434 | 432 | 441 | 427 | 437 | 445 | 462 | 465 | 424 |
| 3 | 384 | 389 | 400 | 403 | 399 | 422 | 409 | 391 | 415 | 383 | 408 | 410 | 371 |
| 4 | 319 | 348 | 370 | 341 | 319 | 348 | 370 | 341 | 319 | 343 | 370 | 341 | 318 |
| 5 | 281 | 313 | 303 | 273 | 289 | 284 | 269 | 277 | 301 | 267 | 271 | 283 | 265 |
| 6 | 254 | 239 | 218 | 231 | 228 | 245 | 237 | 247 | 251 | 217 | 219 | 243 | 212 |
| 7 | 195 | 101 | 196 | 161 | 172 | 164 | 165 | 198 | 174 | 177 | 170 | 204 | 159 |
| 8 | 134 | 147 | 149 | 133 | 155 | 138 | 115 | 140 | 152 | 109 | 135 | 139 | 106 |
| 9 | 100 | 86 | 57 | 84 | 68 | 103 | 96 | 55 | 95 | 87 | 78 | 101 | 53 |
| 10 | 13 | 35 | 29 | 21 | 28 | 2 | 38 | 33 | 44 | 41 | 37 | 14 | 0 |

FIG.35

## FIG.36

## FIG.37

(a)

# FIG.38

SNR

5bit

4bit

3bit                    3bit

2bit                                2bit

TONE INDEX

0    1    2    3    4    5

TONE ORDERED

$b_0'=b_0=2$

$b_1'=b_5=2$

$b_2'=b_1=3$

$b_3'=b_4=3$

$b_4'=b_2=4$

$b_5'=b_3=5$

(b)

DATA FRAME BUFFER

| FAST DATA BUFFER | INTERLEAVED DATA BUFFER |
|---|---|

lsb ... msb | lsb ... msb

| $d_0$ | $d_1$ | $d_2$ | $d_3$ | $d_4$ | $d_5$ | $d_6$ | $d_7$ | $d_0$ | $d_1$ | $d_2$ | $d_3$ | $d_4$ | $d_5$ | $d_6$ | $d_7$ |
|---|---|---|---|---|---|---|---|---|---|---|---|---|---|---|---|

$b_0'+b_1'-1$          $b_2'+b_3'-1$                    $b_4'+b_5'-1$

TONE0    TONE5    TONE1    TONE4    TONE2         TONE3
2bit     2bit     3bit     3bit     4bit          5bit

## INTERNATIONAL SEARCH REPORT

| | International application No. |
| --- | --- |
| | PCT/JP01/06046 |

**A. CLASSIFICATION OF SUBJECT MATTER**
Int.Cl$^7$ H04J11/00

According to International Patent Classification (IPC) or to both national classification and IPC

**B. FIELDS SEARCHED**

Minimum documentation searched (classification system followed by classification symbols)
Int.Cl$^7$ H04J11/00

Documentation searched other than minimum documentation to the extent that such documents are included in the fields searched
Jitsuyo Shinan Koho          1926-2000
Kokai Jitsuyo Shinan Koho    1971-2000

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2000-196471 A (Mitsubishi Electric Corporation), 14 July, 2000 (14.07.00), page 7, left column, lines 7 to 18; page 7, left column, line 46 to right column, line 4   (Family: none) | 1-13 |
| Y | EP 589709 A2 (Matsushita Electric Industrial Co., Ltd.), 30 March, 1994 (30.03.94), Figs. 123, 144 & JP 7-99522 A Figs. 123, 144 | 1-13 |
| E,A | WO 01/33719 A1 (Mitsubishi Electric Corporation), 10 May, 2001 (10.05.01), Figs. 1, 2, 8 & JP 2001-127649 A | 1-13 |
| E,A | JP 2001-86007 A (Mitsubishi Electric Corporation), 30 March, 2001 (30.03.01), Figs. 1, 5   (Family: none) | 1-13 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 September, 2001 (17.09.01) | 25 September, 2001 (25.09.01) |

| Name and mailing address of the ISA/ | Authorized officer |
| --- | --- |
| Japanese Patent Office | |
| Facsimile No. | Telephone No. |

Form PCT/ISA/210 (second sheet) (July 1992)

## INTERNATIONAL SEARCH REPORT

| International application No. |
|---|
| PCT/JP01/06046 |

C (Continuation).  DOCUMENTS CONSIDERED TO BE RELEVANT

| Category* | Citation of document, with indication, where appropriate, of the relevant passages | Relevant to claim No. |
|---|---|---|
| E,A | JP 2001-186023 A (Mitsubishi Electric Corporation), 06 July, 2001 (06.07.01), Figs. 1, 2   (Family: none) | 1-13 |
| E,A | JP 2001-217724 A (Mitsubishi Electric Corporation), 10 August, 2001 (10.08.01), Figs. 1, 2, 5   (Family: none) | 1-13 |

Form PCT/ISA/210 (continuation of second sheet) (July 1992)